# EUROPEAN PATENT SPECIFICATION

(11) **EP 2 744 319 B1**
(45) Date of publication and mention of the grant of the patent: **28.11.2018**
(21) Application number: 12822167.8
(22) Date of filing: 10.07.2012
(51) Int. Cl.: H05K 13/04, H05K 13/08

(54) **SOLDER PRINTING SYSTEM**
LÖTDRUCKSYSTEM
SYSTÈME D'IMPRESSION DE SOUDURE

(30) Priority: 10.08.2011 JP 2011174564
(43) Date of publication of application: 18.06.2014
(73) Proprietor: FUJI Corporation, Chiryu Aichi (JP)
(72) Inventor: KATO, Mitsuaki, Chiryu-shi Aichi 472-8686 (JP); SUZUKI, Takanori, Chiryu-shi Aichi 472-8686 (JP); HIRUKAWA, Ritsuo, Chiryu-shi Aichi 472-8686 (JP)
(74) Representative: Grünecker Patent- und Rechtsanwälte PartG mbB
(86) International application number: PCT/JP2012/067606
(87) International publication number: WO 2013/021770

(56) References cited:
- WO-A1-01/53034
- JP-A- 2004 142 299
- JP-A- 2010 147 288
- JP-A- 2010 253 785
- US-A1- 2004 128 827
- US-A1- 2011 179 638

## Description

### TECHNICAL FIELD

The present invention relates to a system for printing solder cream on a surface of a circuit substrate that constitutes an electric circuit.

### BACKGROUND ART

Recently, in the field of production of electric circuits, it is sought to achieve, in a component mounter configured to mount electric components on a circuit substrate (hereinafter simply referred to as "substrate" where appropriate), a speedup and a multi-lane line for permitting component mounting work to be performed parallel in a plurality of lanes. In association with the speedup and the multi-lane line in the component mounter, it is sought to achieve a multi-lane line also in a solder printing system in which is performed solder printing work that is preliminary work of the component mounting work. In the solder printing system described in the following Patent Literature, a solder printing device is disposed in each of two lanes, so as to achieve the multi-lane line. WO01/53034 concerns a redundant system for assembly of electronic components on substrates comprising a solder printing system according to the preamble portion of claim 1.

### CITATION LIST

### PATENT LITERATURE

Patent Literature 1: JP-A-2010-147288 (Fig. 2)

### SUMMARY OF INVENTION

### TECHNICAL PROBLEM

The solder printing system in which the multi-lane line is achieved (hereinafter referred to as "multi-lane solder printing system" where appropriate") is under development and there still remains plenty of room for improvement. Accordingly, some modifications to the system enables utility of the multi-lane solder printing system to be enhanced. The present invention has been developed in view of such situations. It is therefore an object of the invention to provide a multi-lane solder printing system having high utility.

### SOLUTION TO PROBLEM

To solve the problem indicated above, a solder printing system according to the present invention is a system including: two printers which are disposed side by side in a substrate conveyance direction and each of which has two conveyor lanes on one of which solder printing is performed; and a conveyor-lane changer disposed between the two printers and configured to switch a lane for conveying a substrate between the two conveyor lanes, the system being characterized in that identification information is stored for each of substrates output from the system (output substrates) in association with an order in which the substrates are output (output order), the identification information being information for identifying which one of the two printers has performed printing on each of the substrates output from the system.

### ADVANTAGEOUS EFFECTS OF INVENTION

In an instance where any failure is found in one substrate in any of operation-performing apparatus disposed downstream of the system, the identification information indicated above is material information for investigating the cause of the failure. Accordingly, the solder printing system of the present invention configured to store, for each output substrate, the useful information in association with the output order, offers high convenience in management of the output substrates.

### FORMS OF INVENTION

There will be explained various forms of an invention which is considered claimable (hereinafter referred to as "claimable invention" where appropriate). Each of the forms is numbered like the appended claims and depends from the other form or forms, where appropriate. This is for easier understanding of the claimable invention, and it is to be understood that combinations of constituent elements that constitute the invention are not limited to those described in the following forms. That is, it is to be understood that the claimable invention shall be construed in the light of the following description of various forms and embodiment. It is to be further understood that, as long as the claimable invention is construed in this way, any form in which one or more constituent elements is/are added to or deleted from any one of the following forms may be considered as one form of the claimable invention.

In the following forms, the form (21) corresponds to claim 1. The form (28) corresponds to claim 2. The form (29) corresponds to claim 3. The form (30) corresponds to claim 4. A combination of the form (33) and the form (34) corresponds to claim 5.
(1) A solder printing system, comprising:
   an upstream printer and a downstream printer each including: (a) a first conveyor lane and a second conveyor lane which are disposed side by side in an intersecting direction that intersects a substrate conveyance direction and each of which is configured to convey a circuit substrate in the substrate conveyance direction; and (b) a solder printing device configured to print solder cream on the circuit substrate conveyed by the first conveyor lane; and
   a conveyor-lane changer disposed between the upstream printer and the downstream printer for inputting the circuit substrate conveyed by the first conveyor lane of the upstream printer into the second conveyor lane of the downstream printer and inputting the circuit substrate conveyed by the second conveyor lane of the upstream printer into the first conveyor lane of the downstream printer.

Briefly, in each of the two printers of the solder printing system according to this form, one of the two conveyor lanes is a printing lane in which the solder printing device is provided while the other of the two conveyor lanes is a passing lane in which the solder printing device is not provided and through which the substrate merely passes. Such a printer permits easy construction of a two-lane solder printing system by a combination with the conveyor-lane changer. In addition, such a printer may be disposed in a one-lane electric-circuit production line. Accordingly, such a printer is highly versatile. Therefore, the solder printing system according to this form having the two versatile printers is a simple system.
(2) The solder printing system according to the form (1), wherein a relative positional relationship, in the intersecting direction, between the first conveyor lane and the second conveyor lane in the upstream printer is the same as that in the downstream printer.

An operator performs, on each solder printing device described above, various sorts of associated work such as replacement, adjustment, and cleaning of a mask, and additional supply of solder onto the mask. According to the system of this form, the solder printing devices of the respective two printers are disposed on the same side in the intersecting direction (hereinafter referred to as "conveyance-width direction" where appropriate) that intersects the substrate conveyance direction, whereby a movement path of the operator engaged in the electric circuit production can be shortened. In an instance where the system is disposed in the electric-circuit production line, together with the component mounter, it is preferable that the solder printing devices of the respective two printers be disposed on the same side, in the conveyance-width direction, on which are disposed component suppliers such as feeders that are incorporated in the component mounter.
(3) The solder printing system according to the form (1) or (2), wherein each of the upstream printer and the downstream printer has the first conveyor lane on a front side thereof and the second conveyor lane on a rear side thereof.

In general, an operation panel of the printer is provided on its front side. The solder printing system according to this form makes it possible to considerably shorten the above-indicted movement path of the operator. In most of the electric-circuit production lines, it may be impossible to provide, on the rear side, space large enough for the operator to stand. The present system in this form is convenient in a case where the system is disposed in such electric-circuit production lines.
(4) The solder printing system according to any one of the forms (1)-(3), wherein each of the upstream printer and the downstream printer has a controller for controlling a corresponding one of the upstream printer and the downstream printer, the controller of one of the upstream printer and the downstream printer being configured to control also the conveyor-lane changer.

The above-indicated conveyor-lane changer is operated such that the upstream printer and the downstream printer are operated in conjunction with each other. According to the system of this form, one of the upstream printer and the downstream printer can be operated easily in conjunction with the conveyor-lane changer without providing, in the conveyor-lane changer itself, any controller for controlling the conveyor-lane changer.
(5) The solder printing system according to any one of the forms (1)-(4), wherein, where the conveyor-lane changer is an intermediate lane changer disposed between the upstream printer and the downstream printer, the solder printing system further comprises, as another conveyor-lane changer different from the intermediate lane changer, an input-side lane changer disposed on an upstream side of the upstream printer for selectively inputting the circuit substrate into one of the first conveyor lane and the second conveyor lane of the upstream printer.

According to the system of this form, even where the substrates are supplied from one location, solder printing can be easily performed in the two lanes.
(6) The solder printing system according to the form (5), wherein the upstream printer has a controller for controlling the upstream printer, the controller being configured to control also the input-side lane changer.

According to the system of this form, the input-side lane changer and the upstream printer can be operated easily in conjunction with each other without providing any controller in the input-side lane changer itself.
(7) The solder printing system according to any one of the forms (1)-(6), wherein, where the conveyor-lane changer is an intermediate lane changer disposed between the upstream printer and the downstream printer, the solder printing system further comprises, as another conveyor-lane changer different from the intermediate lane changer, an output-side lane changer disposed on a downstream side of the downstream printer for outputting the circuit substrate at at least one arbitrary output position in the intersecting direction, irrespective of which one of the first conveyor lane and the second conveyor lane of the downstream printer has conveyed the circuit substrate.

According to the system of this form, the substrates conveyed by each of the two conveyor lanes can be output at the same position in the conveyance-width direction, thereby increasing a degree of freedom in configurations of one or more devices and machines disposed downstream of the system in the electric-circuit production line. Conversely, devices and machines having various configurations can be easily disposed downstream of the present system.
(8) The solder printing system according to the form (7), wherein the downstream printer has a controller for controlling the downstream printer, the controller being configured to control also the output-side lane changer.

According to the system of this form, the output-side lane changer and the downstream printer can be operated easily in conjunction with each other without providing any controller in the output-side lane changer itself.
(9) The solder printing system according to any one of the forms (1)-(8), wherein the conveyor-lane changer has a movable conveyor lane that is movable in the intersecting direction, the conveyor-lane changer being configured to effectuate a function thereof by a movement of the movable conveyor lane in the intersecting direction in a state in which the circuit substrate is placed on the movable conveyor lane.

The conveyor-lane changer of the system according to this form includes a device such as a shuttle conveyor described below. Such a device enables lane switching in a simple structure.
(11) The solder printing system according to any one of the forms (1)-(9),
wherein the solder printing system is configured to perform both of (A) first printing work in which solder printing is performed on the circuit substrate by the solder printing device while the circuit substrate is being conveyed by the first conveyor lane of the upstream printer, and the circuit substrate is then conveyed by the second conveyor lane of the downstream printer; and (B) second printing work in which the circuit substrate is conveyed by the second conveyor lane of the upstream printer, and solder printing is then performed on the circuit substrate by the solder printing device while the circuit substrate is being conveyed by the first conveyor lane of the downstream printer, and
wherein printing work by the solder printing system is performable in both of a two-lane parallel printing mode in which the first printing work and the second printing work are performed in parallel; and a one-lane printing mode in which only one of the first printing work and the second printing work is performed.

According to the system of this form, the electric circuit production in various configurations can be effectuated, so that the system is highly versatile. For instance, where the component mounter disposed downstream of the present system has two conveyor lanes and is configured to mount electric components (hereinafter simply referred to as "components" where appropriate) on mutually different two kinds of substrates (different in type, type number, type model, etc.,) in the two conveyor lanes, it is preferable to perform the printing work in the above-indicated two-lane parallel printing mode wherein the kind of the substrate on which the first printing work is to be performed is different from the kind of the substrate on which the second printing work is to be performed. Further, where a production speed of the component mounter is high, namely, where the number of substrates for which component mounting is completed per unit time is large, for instance, it is preferable to perform the printing work in the two-lane parallel printing mode wherein the kind of the substrate on which the first printing work is to be performed is the same as the kind of the substrate on which the second printing work is to be performed. On the other hand, where the production speed of the component mounter is low, it is preferable to perform the printing work in the one-lane printing mode. Thus, the system according to this form can flexibly deal with the electric circuit production in various configurations.
(12) The solder printing system according to the form (11), wherein at least one of the upstream printer and the downstream printer has a second-conveyor-lane operation switch for permitting only an operation of the second conveyor lane thereof in the printing work in the one "lane printing mode.

The second conveyor lane is the so-called passing lane, and the solder printing device is not disposed in the second conveyor lane. In an instance where the printing work is performed in the one-lane printing mode by operating only the second conveyor lane, the solder printing device of the printer in which the second conveyor lane operates does not operate. Accordingly, it is possible to perform various sorts of work such as adjustment and maintenance on the solder printing device. Even in such a case, the conveyor-lane changer is being operated. Therefore, if the operator inadvertently or carelessly performs work on the solder printing device, there may arise a risk that the conveyor-lane changer is hindered from smoothly operating. In the system according to this form, the second-conveyor-lane operation switch is provided in at least one of the two printers, thereby obviating such a risk. Further, owing to provision of the second-conveyor-lane operation switch, the system of this form enables easy starting of the printing work in the one-lane printing mode. Moreover, where the system is configured not to perform electric power supply in relation to at least one of the first conveyor lane and the solder printing device disposed therein even if the second-conveyor-lane operation switch is operated, for instance, it is possible to minimize standby power in the printing work in the one-lane printing mode. In this respect, the second-conveyor-lane operation switch is preferably provided in each of the upstream printer and the downstream printer.

The second-conveyor-lane operation switch and various switches described below are not limited to switches each having a mechanical contact. For instance, each switch may be configured such that a touch on a part of a screen of a touch panel causes the part to function as a switch. Further, the switch is not necessarily limited to the one having only one operation button (that may be referred to as "operation key"), but may be constituted by a combination of a plurality of operation buttons. Briefly, the switch may be configured to function by operating at least two operation buttons.
(13) The solder printing system according to the form (12), wherein the second-conveyor-lane operation switch is configured to switch the operation of the second conveyor lane so as to be selectively permitted or prohibited.

The second-conveyor-lane operation switch according to this form may be considered as a switch functioning as the so-called toggle switch. In the system of this form that employs such a switch, the second conveyor lane that is being operated can be stopped by a simple switching operation.
(14) The solder printing system according to any one of the forms (11)-(13), wherein at least one of the upstream printer and the downstream printer has a notifier configured to notify an operator that only the second conveyor lane is permitted to be operated in the printing work in the one-lane printing mode.

As described above, because the solder printing device is not disposed in the second conveyor lane, it is difficult for the operator to recognize that only the lane in question is being operated. Therefore, there may arise a risk that the operator inadvertently or carelessly performs work on the solder printing device as described above and, as a result, the operation of the second conveyor lane or the conveyor-lane changer may be hindered. In the system according to this form, the notifier notifies the operator the fact that only the second conveyor lane is being operated, thereby effectively preventing an occurrence of such a risk in the printing work in the one-lane printing mode. In this respect, the notifier may be configured to alert the operator by sound or light. For instance, there may be employed Patlite (trademark), a buzzer or the like, as the notifier. There may be also employed, as the notifier, a display capable of displaying characters, figures, symbols, etc., indicating the fact that only the second conveyor lane is being operated.
(15) The solder printing system according to the form (14), wherein each of the upstream printer and the downstream printer has an operation panel having a display, and information that only the operation of the second conveyor lane is permitted is displayed on the display, so that the operation panel functions as the notifier.

Not only the printers, but also most of circuit-substrate-related-operation performing apparatus (hereinafter simply referred to as "operation-performing apparatus" where appropriate) usually have an operation panel functioning as an input/output terminal of its own controller. In most cases, the operation panel has a generally used display. This form includes a form that permits the display to function as the notifier by displaying, on the display, characters, figures, symbols, etc., indicating the fact that only the second conveyor lane is being operated. Because the system of this form does not intentionally employ any dedicated notifier, the system is relatively inexpensive.
(16) The solder printing system according to any one of the forms (11)-(15), wherein at least one of the upstream printer and the downstream printer has a first-conveyor-lane operation switch for permitting only an operation of the first conveyor lane thereof in the printing work in the one-lane printing mode.

The first-conveyor-lane operation switch according to this form may be considered as a switch having, with respect to the first conveyor lane, a function similar to a function that the second-conveyor-lane operation switch has with respect to the second conveyor lane. As in the case in which the second-conveyor-lane operation switch is provided, in the system according to this form in which the first-conveyor-lane operation switch is provided, the printing work in the one-lane printing mode can be simply started. Moreover, where the system is configured not to perform electric power supply in relation to the second conveyor lane even if the first-conveyor-lane operation switch is operated, for instance, it is possible to minimize standby power in the printing work in the one-lane printing mode. In this respect, like the second-conveyor-lane operation switch, the first-conveyor-lane operation switch is preferably provided in each of the upstream printer and the downstream printer.

In an instance where the first-conveyor-lane operation switch and the second-conveyor-lane operation switch are both provided in one printer, a part of an operation of each of the two switches may be performed by the same operation button. In other words, a part of the one of the two switches and a part of the other of the two switches may be commonly used. For instance, in a situation in which an operation button for selecting at least one of the first conveyor lane and the second conveyor lane is provided and one of the first conveyor lane and the second conveyor lane is being selected by the operation button, the selected one of the first conveyor lane and the second conveyor lane may be permitted to be operated by another operation button.
(17) The solder printing system according to the form (16), wherein the first-conveyor-lane operation switch is configured to switch the operation of the first conveyor lane so as to be selectively permitted or prohibited.

The first-conveyor-lane operation switch according to this form may be considered as a switch functioning as the so-called toggle switch. In the system of this form that employs such a switch, the first conveyor lane that is being operated can be stopped by a simple switching operation.
(18) The solder printing system according to the form (11), wherein at least one of the upstream printer and the downstream printer has a both-conveyor-lane operation switch for permitting both of the first conveyor lane and the second conveyor lane to be operated at one time in the printing work in the two-lane parallel printing mode.

Owing to provision of the both-conveyor-lane operation switch, the system of this form enables easy starting of the printing work in the two-lane parallel printing mode. In this respect, like the first-conveyor-lane operation switch and the second-conveyor-lane operation switch, the both-conveyor-lane operation switch is preferably provided in each of the upstream printer and the downstream printer.

In an instance where at least one of the first-conveyor-lane operation switch and the second-conveyor-lane operation switch and the both-conveyor-lane operation switch are provided in one printer, a part of an operation of each of the switches may be performed by the same operation button. In other words, a part of at least one of the first-conveyor-lane operation switch and the second-conveyor-lane operation switch and a part of the both-conveyor-lane operation switch may be commonly used. For instance, in a situation in which an operation button for selecting at least one of the first conveyor lane and the second conveyor lane is provided and both of the first conveyor lane and the second conveyor lane are being selected by the operation button, both of the selected first conveyor lane and second conveyor lane may be permitted to be operated by another operation button.
(21) The solder printing system according to any one of the forms (1)-(18), further comprising an information storage device to store performed printing information for each of the circuit substrates output from the solder printing system, in association with an order in which the circuit substrates are output, the performed printing information including printing-apparatus identification information that is information for identifying which one of the solder printing device of the upstream printer and the solder printing device of the downstream printer has printed the solder cream on said each of the circuit substrates output from the solder printing system.

The solder printing system is disposed in the electric-circuit production line, and the circuit-substrate-related-operation performing apparatus (hereinafter simply referred to as "operation-performing apparatus" where appropriate) configured to perform work on the substrates is disposed downstream of the system. The performed printing information that is information for indicating what sort of printing work has been performed on the substrates is useful information for the electric-circuit production line. However, the performed printing information of the substrates that have been output (hereinafter referred to as "output substrates" where appropriate) cannot be grasped unless the output substrates are managed in some way by making some markings on the output substrates, for instance. The system of this form employs a management technique of storing the useful information for each of the output substrates in association with the order in which the substrates are output. Accordingly, the system offers high convenience in management of the substrates that have been output (hereinafter referred to as "output substrates" where appropriate).

The printing-apparatus identification information is considerably useful among the performed printing information. The printing-apparatus identification information is information for identifying which one of the two printers of the system has performed printing on the substrates. For example, in an instance where a failure is found in one output substrate in any of the operation-performing apparatus disposed downstream of the system when the printing work is being performed in the two-lane parallel printing mode on the substrates of one kind, it is material information to grasp which one of the two printers has performed printing on the substrate in question for investigating the cause of the failure. Accordingly, the information storage device sufficiently exhibits its function in the printing work in the two-lane parallel printing mode performed on the substrates of one kind.

The system according to this form may be configured such that the performed printing information stored in the information storage device is transmitted to other devices, machines, etc., so as to be utilized by the other devices, machines, etc. Alternatively, the performed printing information may be utilized exclusively in the processing performed in the system so as to be displayed, for instance, without being transmitted. Where the performed printing information is configured not to be transmitted, the system is simplified and the electric-circuit production line is accordingly simplified and low in the cost.
(22) The solder printing system according to the form (21), which is disposed in an electric-circuit production line,
wherein the information storage device is configured to store the performed printing information for one circuit substrate at least in a time period from a time point when the one circuit substrate is output from the solder printing system to a time point when a specific operation-performing apparatus disposed on a downstream side of the solder printing system completes work on the one circuit substrate.

The "specific operation-performing apparatus" described in this form may be an operation-performing apparatus such as a printing-result inspecting machine configured to inspect the result of the printing work by the solder printing system or a component mounter configured to mount components on the substrate on which solder has been printed by the solder printing system. Further, the "specific operation-performing apparatus" may be an apparatus configured to convey the substrate to the operation-performing apparatus or to permit the substrate to wait before being input to the operation-performing apparatus, on the downstream side of the solder printing system. The "specific operation-performing apparatus" is preferably an operation-performing apparatus that can find a failure in the substrate, in particular, a failure in the printing work. From this viewpoint, the printing-result inspecting machine is preferable as the "specific operation-performing apparatus". The information storage device sufficiently exhibits its function by storing the performed printing information of one substrate at least until the operation-performing apparatus completes work on the one substrate.
(23) The solder printing system according to the form (21) or (22), wherein the information storage device is configured to store the performed printing information at least for each of the circuit substrates including: a most-recently-output circuit substrate that is the most recently output from the solder printing system; and a preset number of circuit substrates that precede the most-recently-output substrate.

The "preset number" described in this form may be determined considering that the performed printing information is sufficiently utilized, whereby the information storage device sufficiently exhibits its function in the solder printing system of this form.
(24) The solder printing system according to the form (23), which is disposed in an electric-circuit production line,
wherein the preset number is equal to the number of circuit substrates that are output from the solder printing system in a time period from a time point when one circuit substrate is output from the solder printing system to a time point when a specific operation-performing apparatus disposed on a downstream side of the solder printing system completes work on the one circuit substrate.

This form relates to one example of the preset number explained above. The substrate output from the solder printing system is sequentially conveyed and reaches the specific operation-performing apparatus. Thereafter, the operation-performing apparatus completes work on the substrate. Accordingly, where the preset number is made equal to the number of substrates that are output, subsequent to one output substrate, before the operation-performing apparatus completes work on the one output substrate, the information storage device stores the performed printing information for all of the output substrates until the specific operation-performing apparatus completes work on the one output substrate. By thus determining the preset number, the solder printing system of this form permits the information storage device to sufficiently exhibit its function.
(25) The solder printing system according to the form (24), wherein the information storage device is configured such that the preset number is changeable.

Where the preset number is made changeable depending upon the configuration of the electric-circuit production line in which the present system is disposed, e.g., depending upon the configuration relating to the substrate conveyance between the specific operation-performing apparatus and the system, the system of this form is widely available in the electric-circuit production line in various configurations.
(26) The solder printing system according to any one of the forms (21)-(25), wherein the information storage device is configured to update details stored therein every time one circuit substrate is output from the solder printing system.

The substrates are output from the system to the downstream side one after another. Accordingly, by updating details stored in the information storage device every time one circuit substrate is output, there is stored the performed printing information successively for the output substrates. Therefore, the output substrates can be adequately managed in the solder printing system according to this form.
(27) The solder printing system according to any one of the forms (21)-(26), wherein the information storage device is provided in the downstream printer.

In the solder printing system in which the two printers are disposed, the performed printing information is fixed at a time point when the work by the downstream printer is started or completed. Therefore, the system of this form ensures adequate management of the output substrates in a simple configuration, namely, without involving communication among devices and machines. For instance, by permitting the controller of the downstream printer to function as the information storage device described above, an additional information storage device need not be provided. Accordingly, the output substrates can be adequately managed in the electric-circuit production line that is relatively inexpensive.
(28) The solder printing system according to any one of the forms (21)-(27), further comprising an information display device configured to display the performed printing information stored in the information storage device for said each of the circuit substrates output from the solder printing system, in association with the order in which the circuit substrates are output.

The output substrates can be more adequately managed by not only storing the performed printing information described above but also displaying the performed printing information. Therefore, the system of this form ensures high convenience in terms of management of the output substrates. Because the performed printing information is displayed in the system, there is no need of transmitting the performed printing information outside the system. Accordingly, the output substrates can be adequately managed in the electric-circuit production line that is relatively inexpensive.
(29) The solder printing system according to the form (28), which is disposed in an electric-circuit production line,
wherein the information display device is configured to display a screen on which is set at least one display area that is associated with at least one of: (A) a standby position at which said each of the circuit substrates output from the solder printing system is kept on standby before reaching a specific operation-performing apparatus disposed on a downstream side of the solder printing system; and (B) a work position in the specific operation-performing apparatus,
wherein the information display device being configured to display, on each of the at least one display area, the performed printing information of one of the circuit substrates that is located at a position corresponding to one of the at least one display area.

In the system according to this form, the performed printing information is displayed together with images that correspond to respective positions of one or more of the devices and machine of the electric-circuit production line, thereby enhancing viewability of the information. In other words, the system according to this form enables the operator to recognize the information by appealing to the vision of the operator. It is preferable in this form to constitute the information display device such that the information display device displays a screen on which are set a plurality of display areas that are associated with both of the standby position and the work position.
(30) The solder printing system according to the form (29),
wherein one of the at least one display area is associated with at least the standby position, and
wherein the information display device is configured such that the number of at least one display area is changeable depending upon the number of standby positions.

Where the number of the at least one display area is made changeable depending upon the configuration of the electric-circuit production line in which the system is disposed, e.g., depending upon the configuration relating to the substrate conveyance between the specific operation-performing apparatus and the system, the system of this form is widely available in electric-circuit production lines with various configurations.
(31) The solder printing system according to any one of the forms (28)-(30), wherein the information display device is configured to update details displayed thereon every time one circuit substrate is output from the solder printing system

As explained above, the substrates are output from the system to the downstream side one after another. Accordingly, by updating details displayed by the information display device every time one circuit substrate is output, the performed printing information for the substrates that are sequentially output can be recognized by the operator. The solder printing system of this form ensures management of the output substrates that appeals to the vision of the operator.
(32) The solder printing system according to any one of the forms (21)-(31), wherein the information display device is provided in the downstream printer.

Usually, printers have an operation panel, and it is possible to permit the operation panel to function as the information display device. The system according to this form ensures adequate management of the output substrates in the electric-circuit production line that is relatively inexpensive, in a simple configuration, namely, without additionally providing an information display device.
(33) The solder printing system according to any one of the forms (21)-(32),
wherein the solder printing device of each of the upstream printer and the downstream printer is configured to perform printing such that a squeegee is move in one of opposite directions, and
wherein the performed printing information includes printing-direction identification information that is information for identifying in which one of the opposite directions the squeegee was moved when the solder printing device performed printing on the circuit substrate

In this form, a limitation is added in relation to the performed printing information. The printing-direction identification information is material information for investigating a cause of a printing failure. The system according to this form ensures high convenience in management of the output substrates by storing such information on the output substrates.
(34) The solder printing system according to any one of the forms (21)-(33),
wherein the solder printing device of each of the upstream printer and the downstream printer is configured to perform printing such that a squeegee is moved with a mask pressed onto the circuit substrate and has a cleaning mechanism configured to clean the mask arbitrarily or based on a predetermined cleaning condition prior to the printing, and
wherein the performed printing information includes post-cleaning printing identification information that is information for identifying one circuit substrate as an initially-printed circuit substrate after cleaning that is a circuit substrate on which the printing is initially performed after the mask has been cleaned by the cleaning mechanism.

In this form, a limitation is added in relation to the performed printing information. The post-cleaning printing identification information is useful information for investigating a cause of a printing failure. The system according to this form ensures high convenience in management of the output substrates by storing such information on the output substrates.

### BRIEF DESCRIPTION OF DRAWINGS

Fig. 1 is a perspective view showing a part of an electric-circuit production line including a solder printing system according to one embodiment of the claimable invention.
Fig. 2 is a conceptual view showing an internal structure of a part of the electric-circuit production line of Fig. 1 focusing on conveyor lanes by which circuit substrates are conveyed in the electric-circuit production line.
Figs. 3A-3C are conceptual views showing the substrates that pass the electric-circuit production line in a state in which the solder printing system is performing printing work in a two-lane parallel printing mode or in a one-lane printing mode.
Fig. 4A is a view showing a lane and substrate-kind selecting screen displayed on an operation panel of each of two printers of the solder printing system and Fig. 4B is a view showing an operation-status display screen displayed on the operation panel of an upstream printer.
Fig. 5 is a view showing an operation-status display screen displayed on the operation panel of a downstream printer of the solder printing system.
Fig. 6 is a block diagram showing a functional structure of a controller of the downstream printer of the solder printing system.
Fig. 7 is a view conceptually showing an output-substrate management table stored in a data storage portion of the controller shown in Fig. 6.

### DESCRIPTION OF EMBODIMENT

There will be explained in detail a solder printing system according to one embodiment for carrying out the claimable invention. It is to be understood that the claimable invention may be embodied with various changes and modifications based on the knowledge of those skilled in the art, in addition to the following embodiment and various forms described in the FORMS OF INVENTION.

### EMBODIMENT

### <Configuration of Electric-Circuit Production Line>

### i) Overall Configuration

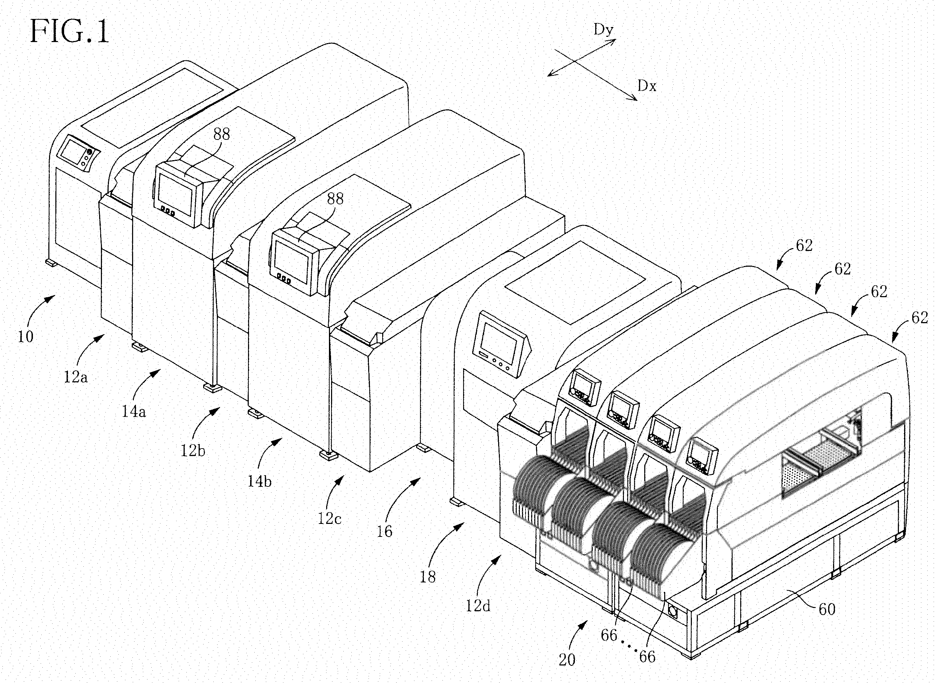

A solder printing system according to one embodiment is disposed in an electric-circuit production line a part of which is shown in Fig. 1, for instance. In the electric-circuit production line, there are disposed from an upstream side toward a downstream side in a substrate conveyance direction Dx, i.e., a direction from the upper left to the lower right in Fig. 1, a substrate supplier 10, a first shuttle conveyor 12a, an upstream printer 14a, a second shuttle conveyor 12b, a downstream printer 14b, a third shuttle conveyor 12c, a buffer conveyor 16, a printing-result inspecting machine 18, a fourth shuttle conveyor 12d, and a component mounter 20. While not shown, a mounting-result inspecting machine, a reflow furnace, and so on are disposed downstream of the component mounter 20. The electric-circuit production line is constituted by the devices and the machines described above. In the following explanation, a direction that intersects the substrate conveyance direction Dx, namely, a width direction of the line (a width direction in conveyance) is referred to as a conveyance-width direction Dy where appropriate. Further, the upstream side and the downstream side in the substrate conveyance direction Dx may be simply referred to as "upstream side" and "downstream side", respectively. The front side (the lower left side in Fig. 1) and the rear side (the upper right side in Fig. 1) of the electric-circuit production line in the conveyance-width direction Dy may be respectively referred to as "front side" and "rear side" of the devices and the machines where appropriate.

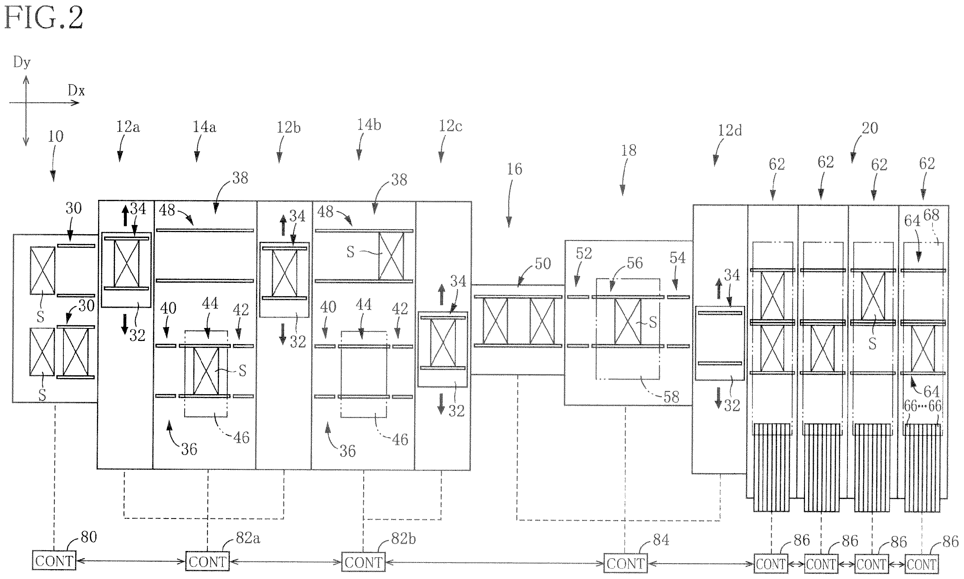

There will be explained in detail each of the devices and the machines with reference also to Fig. 2 showing an internal structure of a part of the electric-circuit production line. It is noted that Fig. 2 is a conceptual view illustrated focusing on conveyor lanes by which a circuit substrate (hereinafter simply referred to as "substrate" where appropriate) is conveyed.

### ii) Substrate Supplier

The substrate supplier 10 is a device for supplying stacked substrates S sequentially one by one. Two tables (not shown) each for stacking the substrates S thereon are provided at an upstream portion of the substrate supplier 10, and two conveyors 30 are provided downstream of the corresponding tables. The substrates S stacked on each table are transferred to the corresponding conveyor 30 by a corresponding transfer mechanism (not shown) sequentially from an uppermost one of the stacked substrates S, and the transferred substrate S is output to the first shuttle conveyor 12a by the conveyor 30. One table, one conveyor 30, and one transfer mechanism are provided at each of a front-side portion and a rear-side portion of the substrate supplier 10. Thus, the substrate supplier 10 is capable of supplying the substrates S at two positions, i.e., on the front side and the rear side.

In the electric-circuit production line, various conveyors including the conveyors 30 are disposed in the devices and the machines described above. Each of the conveyors is an ordinary one including a pair of support plates, a pair of conveyor belts respectively supported by the support plates, and a belt rotating mechanism configured to rotate the conveyor belts in synchronism with each other. In each of the conveyors except for the ones disposed in the component mounter 20 that will be explained, one of the support plates located on the front side is configured to be movable in the conveyance-width direction Dy, and a distance between the two support plates (hereinafter referred to as "conveyor width" where appropriate) is adjustable so as to correspond to a dimension, in the conveyance-width direction Dy, of the substrate S to be conveyed (hereinafter referred to as "substrate width" where appropriate). Except for some of the conveyors, a length of each of the conveyors in the substrate conveyance direction Dx (hereinafter referred to as "conveyor length" where appropriate) is made longer than a dimension, in the substrate conveyance direction Dx, of a maximum-sized substrate S that can be produced by the electric-circuit production line. (The dimension of the substrate S on the substrate conveyance direction Dx is referred to as "substrate length" where appropriate.) In the following description, an explanation of conveyors provided in other devices and machines is dispensed with except for special cases.

### iii) First Shuttle Conveyor

The first shuttle conveyor 12a disposed between the substrate supplier 10 and the upstream printer 14a is a device configured to deliver the substrate S supplied from the substrate supplier 10 to the upstream printer 14a. As described above, the substrate supplier 10 is configured to supply, at the front-side supply position, the substrates S stacked on the front-side table and to supply, at the rear-side supply position, the substrates S stacked on the rear-side table. As will be explained in detail, the upstream printer 14a has two conveyor lanes that are arranged in the conveyance-width direction Dy. The first shuttle conveyor 12a has a function to distribute the substrate S supplied at each of the two supply positions to one of the two conveyor lanes.

The first shuttle conveyor 12a has a shuttle base 32 that is a base movable in the conveyance-width direction Dy, and a conveyor 34 is supported by the shuttle base 32. By the movement of the shuttle base 32, the conveyor 34 is positioned, in the conveyance-width direction Dy, relative to one of the two conveyors 30 of the substrate supplier 10 that are disposed so as to correspond to the two supply positions. Subsequently, the conveyor 34 receives the substrate S from one of the two conveyors 30 relative to which the conveyor 34 is positioned. Thereafter, the shuttle base 32 moves for permitting the conveyor 34 that has received the substrate S to be positioned relative to a conveyor of one of the two conveyor lanes of the upstream printer 14a, and the substrate S is then delivered to the conveyor of the one of the two conveyor lanes. The delivery of the substrate S from the conveyor 34 to the conveyor of the one of the two conveyor lanes of the upstream printer 14a is performed such that the conveyors in question are synchronously operated at the same speed. In this respect, delivery of the substrate S between any two conveyors disposed in the devices and the machines of the electric-circuit production line is similarly performed, and accordingly, an explanation of the operations of the conveyors as to the delivery of the substrate S is dispensed with in the following description of the devices and the machines.

In the present electric-circuit production line, three other shuttle conveyors, i.e., second, third, and four shuttle conveyors 12b, 12c, 12d, are disposed in addition to the first shuttle conveyor 12a. Because the shuttle conveyors 12a-12d are identical in structure, an explanation of the structure and the operation of the second, third, and fourth shuttle conveyors 12b, 12c, 12d is dispensed with. In the following explanation, where it is not necessary to distinguish the first through fourth shuttle conveyors 12a-12d from one another, the shuttle conveyors 12a-12d are collectively referred to as "shuttle conveyor 12" where appropriate.

### iv) Printer

In the present electric-circuit production line, two solder printers having substantially the same structure, more specifically, the upstream printer 14a and the downstream printer 14b, are disposed. (Hereinafter, where it is not necessary to distinguish the two printers 14a, 14b from each other, the two printers 14a, 14b are collectively referred to as "printer 14" where appropriate.) The printer 14 has the two conveyor lanes, namely, a front conveyor lane 36 (first conveyor lane) and a rear conveyor lane 38 (second conveyor lane), which are disposed side by side in the conveyance-width direction Dy and each of which is configured to convey the substrate S in the substrate conveyance direction Dx. The front conveyor lane 36 is constituted by an input conveyor 40 configured to operate when the substrate S is input thereto from the first shuttle conveyor 12a, an output conveyor 42 configured to operate when the substrate S is output therefrom to the second shuttle conveyor 12b, and an intermediate conveyor 44 disposed between the input conveyor 40 and the output conveyor 42. A solder printing device 46 is disposed in the front conveyor lane 36. More specifically, the intermediate conveyor 44 is incorporated in the solder printing device 46. The substrate S that has been input from the first shuttle conveyor 12a to the intermediate conveyor 44 via the input conveyor 40 is stopped at a predetermined printing work position by the intermediate conveyor 44, and solder is printed thereon at the printing work position by the solder printing device 46. The substrate S on which the solder has been printed is output to the second shuttle conveyor 12b via the output conveyor 42. That is, the front conveyor lane 36 is the conveyor lane on which solder printing is performed on the substrate S. On the other hand, the rear conveyor lane 38 is constituted by one conveyor 48. The rear conveyor lane 38 is the conveyor lane for permitting the substrate S to merely pass the upstream printer 14a.

The solder printing device 46 is the so-called screen printing device and is configured to form a plurality of solder pads (that may be referred to as "solder lands") by attaching, to the surface of the substrate S, solder cream in an arbitrary pattern. The solder printing device 46 has a mask in which a plurality of openings are formed so as to correspond to the pattern of the solder pads. The substrate S positioned at the above-indicated printing work position is pressed onto the lower surface of the mask. The solder cream is supplied on the upper surface of the mask. A squeegee is moved along the upper surface of the mask with the substrate S pressed onto the lower surface of the mask, whereby the solder is printed on the surface of the substrate S through the openings of the mask. The solder printing device 46 is well known in the art, and therefore an illustration of the structure and a detailed explanation of the solder printing device 46 are dispensed with.

### v) Second Shuttle Conveyor

The second shuttle conveyor 12b disposed between the upstream printer 14a and the downstream printer 14b is a device configured to deliver the substrate S from the upstream printer 14a to the downstream printer 14b. More specifically, the second shuttle conveyor 12b has a function to deliver the substrate S which has passed the front conveyor lane 36 of the upstream printer 14a and on which solder printing has performed to the rear conveyor lane 38 of the downstream printer 14b and a function to deliver the substrate S that has passed the rear conveyor lane 38 of the upstream printer 14a to the front conveyor lane 36 of the downstream printer 14b for solder printing by the downstream printer 14b.

### vi) Third Shuttle Conveyor

The third shuttle conveyor 12c disposed between the downstream printer 14b and the buffer conveyor 16 is a device configured to deliver the substrate S from the downstream printer 14b to the buffer conveyor 16. The buffer conveyor 16 (which will be later explained) has only one conveyor lane. The third shuttle conveyor 12c has a function to gather the substrates S output from the two conveyor lanes of the downstream printer 14b to the one conveyor lane.

### vii) Solder Printing System

In the present electric-circuit production line, the solder printing system is established by the two printers 14 and the three shuttle conveyors 12. In the system, each of the two printers 14 has, on its front side, the conveyor lane in which the solder printing device 46 is provided, i.e., a printing lane, and has, on its rear side, the conveyor lane through which the substrate S merely passes without solder printing being performed, i.e., a passing lane. In other words, in the two printers 14, the positional relationship between the printing lane and the passing lane is the same in the conveyance-width direction Dy. An operation panel of each of the devices and the machines of the present electric-circuit production line is provided on the front side thereof, and an operator is involved in the work on the front side of the line. The printing lane is provided on the front side in each printer 14, thereby facilitating monitoring of printing work by the solder printing device 46 and enabling the operator to easily perform associated work such as setups and changeovers due to the change in the kind of the substrates and replacement and cleaning of the mask.

In the solder printing system, the three shuttle conveyors 12 have a function to change the conveyor lane by which the substrate S is conveyed in the printer 14 or a function to change the conveyor lane by which the output substrate S is received. That is, each of the three shuttle conveyors 12 functions as a conveyor-lane changer configured to change the conveyor lanes of the printer 14. More specifically, the first shuttle conveyor 12a functions as an input-side lane changer configured to inputting the substrate S selectively into one of the front conveyor lane 36 and the rear conveyor lane 38 of the upstream printer 14a. The second shuttle conveyor 12b functions as an intermediate lane changer configured to input the substrate S conveyed by the front conveyor lane 36 of the upstream printer 14a into the rear conveyor lane 38 of the downstream printer 14b and to input the substrate S conveyed by the rear conveyor lane 38 of the upstream printer 14a into the front conveyor lane 36 of the downstream printer 14b. The third shuttle conveyor 12c functions as an output-side lane changer configured to output the substrate S at at least one arbitrary output position in the conveyance-width direction Dy, irrespective of which one of the front conveyor lane 36 and the rear conveyor lane 38 of the downstream printer 14b has conveyed the substrate S.

Each of the three shuttle conveyors 12 may be considered as having a relatively short conveyor lane defined by the conveyor 34. The conveyor 34 moves in the conveyance-width direction Dy by the movement of the shuttle base 32 in the conveyance-width direction Dy. Accordingly, the conveyor lane of each of the three shuttle conveyors 12 may be considered as a movable conveyor lane that is movable in the conveyance-width direction Dy. Each of the three shuttle conveyors 12 is configured to effectuate its own function, namely, the function to change the conveyor lanes of the printer 14, by the movement of the movable conveyor lane with the substrate S placed thereon.

### viii) Buffer Conveyor

The buffer conveyor 16 is a conveyor device configured to deliver the substrate S output from the third shuttle conveyor 12c, namely, from the solder printing system, to the printing-result inspecting machine 18. A single conveyor 50 is disposed in the buffer conveyor 16. Accordingly, the buffer conveyor 16 has only one conveyor lane. It is noted that the conveyor 50 has a length that permits two substrate S to be placed thereon.

As will be later explained, the buffer conveyor 16 operates as a conveyor device configured to permit the substrates S to merely pass therethrough without being stopped in an instance where the electric-circuit production line produces, in parallel, the substrates in two kinds having mutually different substrate widths. In this instance, after the printing-result inspecting machine 18 completes inspection work on one substrate S, the third shuttle conveyor 12c and the buffer conveyor 16 are operated in synchronism with timing at which the one substrate S is output from the printing-result inspecting machine 18, whereby the substrate S placed on the third shuttle conveyor 12c is input to the printing-result inspecting machine 18 without being stopped. On the other hand, in an instance where the substrates in two kinds having the same substrate width are produced in parallel or an instance where the substrates S in a single kind are produced in one lane or in two lanes, two substrates S are kept on standby on the conveyor 50, as shown in Fig. 2. In this instance, after the printing-result inspecting machine 18 completes inspection work on one substrate S, the conveyor 50 is operated by a pitch corresponding to one substrate in synchronism with timing when the one substrate S is output from the printing-result inspecting machine 18, for inputting one substrate from the third shuttle conveyor 12c and for outputting one substrate S to the printing-result inspecting machine 18.

### ix) Printing-Result Inspecting Machine

The printing-result inspecting machine 18 is an operation-performing apparatus configured to inspect a result of the printing work performed by the printer 14. In the printing-result inspecting machine 18, one conveyor lane is provided. As in the printer 14, the conveyor lane is constituted by an input conveyor 52, an output conveyor 54, and an intermediate conveyor 56. A printing-result inspecting device 58 is constructed so as to incorporate the intermediate conveyor 56. The substrate S input from the buffer conveyor 16 to the intermediate conveyor 56 via the input conveyor 52 is stopped at a predetermined inspection work position by the intermediate conveyor 56 and is subsequently subjected to inspection work at the inspection work position by the printing-result inspecting device 58. The substrate S that has been subjected to the inspection is output to the fourth shuttle conveyor 12d via the output conveyor 54.

The printing-result inspecting device 58 is constituted by: an image taking head having a camera for taking an image of the surface of the substrate S; an XY-robot type moving device configured to move the image taking head along the substrate S; and a processor configured to perform inspection processing based on data of the image taken by the camera. The processor is configured to obtain positions, areas, thicknesses, etc., of the solder pads formed on the substrate S by image processing the data and to determine whether or not adequate solder pads are formed based on the obtained positions, areas, thicknesses, etc., namely, whether or not solder printing has been adequately performed. The printing-result inspecting device 58 is well known in the art, and therefore an illustration of the structure and a detailed explanation of the printing-result inspecting device 58 are dispensed with.

x) Fourth Shuttle Conveyor

The fourth shuttle conveyor 12d disposed between the printing-result inspecting machine 18 and the component mounter 20 is a device configured to deliver the substrate S that has been subjected to the inspection work from the printing-result inspecting machine 18 to the component mounter 20. As will be later explained, the component mounter 20 has two conveyor lanes. The fourth shuttle conveyor 12d has a function to distribute the substrate S to one of the two conveyor lanes.

### xi) Component Mounter

The component mounter 20 is an operation-performing apparatus configured to mount, on the solder-printed substrate S, electric components (hereinafter simply referred to as "components" where appropriate) that constitute an electric circuit. The component mounter 20 is also called a component placer. The component mounter 20 is constituted by one base 60 and four component mounting modules 62 arranged on the base 60 along the substrate conveyance direction Dx. Each of the four component mounting modules 62 has a conveyor unit having two conveyors 64, component feeders 66 each functioning as a component supplier, and a component mounting device 68 configured to mount the components supplied from the component feeder 66 onto the substrates S.

The conveyor unit of each component mounting module 62 is constructed such that the two conveyors 64 are arranged in the conveyance-width direction Dy without spacing therebetween. The conveyor width of the conveyor 64 on the rear side is adjusted by moving the conveyor 64 on the front side in the conveyance-width direction Dy. In each component mounting module 62, the conveyor 64 on the front side constitutes a front-side conveyor lane while the conveyor 64 on the rear side constitutes a rear-side conveyor lane. In other words, the component mounter 20 has two conveyor lanes. The four conveyors 64 constituting each conveyor lane is configured such that adjacent ones in the substrate conveyance direction Dx are synchronously operated, so as to cooperate to convey one substrate S. The substrate S being conveyed is stopped at a mounting work position set for each component mounting module 62, and a component mounting work by the component mounting device 68 of each component mounting module 62 is performed on the substrate S at the mounting work position. One substrate S is conveyed by each conveyor lane, and the component mounting work in the four component mounting modules 62 is sequentially performed, so that the component mounting work on one substrate S is completed.

The component mounting device 68 includes a mounting head having suction nozzles each as a component holding device, and an XY-robot type moving device configured to move the mounting head between the component feeder 66 and the substrate. The mounting head is moved to a position above the component feeder 66, and the suction nozzles are moved downward at that position, whereby the suction nozzles suction-hold the components supplied from the component feeder 66. The mounting head is moved to a position above the substrate S with the components held by the suction nozzles, and the suction nozzles are moved downward at that position, whereby the components held by the suction nozzles are mounted on the substrate S. This mounting operation is repeated to perform the component mounting work. The component mounting device 68 is well known in the art, and therefore an illustration of the structure and a detailed explanation of the component mounting device 68 are dispensed with.

### xii) Control System

As schematically shown in Fig. 2, in the present electric-circuit production line, the substrate supplier 10, the upstream printer 14a, the downstream printer 14b, the printing-result inspecting machine 18, the four component mounting modules 62 of the component mounter 20 has respective controllers 80, 82a, 82b, 84, 86 for controlling their own operations. Each of the controllers 80-86 is constituted mainly by a computer. On the other hand, the first through fourth shuttle conveyors 12a-12d and the buffer conveyor 16 do not have their own controllers. The first shuttle conveyor 12a and the second shuttle conveyor 12b are controlled by the controller 82a of the upstream printer 14a. The third shuttle conveyor 12c is controlled by the controller 82b of the downstream printer 14b. The buffer conveyor 16 and the fourth shuttle conveyor 12d are controlled by the controller 84 of the printing-result inspecting machine 18. In the following explanation, the controller 82a of the upstream printer 14a and the controller 82b of the downstream printer 14b will be collectively referred to as "controller 82" where it is necessary to distinguish the two controllers 82a, 82b from each other.

Each of the controllers 80-86 is configured to control work performed by the corresponding device, machine or module that the controller controls, more specifically, the work by the solder printing device 46, the work by the printing-result inspecting device 58, or the work by the component mounting device 68. Each controller 80-86 stores operation data of the device or the like as a control target thereof, which operation data corresponds to the kind (such as type, type number and type name) of the substrates on which the device performs the work. (The operation data is data on which an operation program is based and is called "recipe".) Each device is controlled based on the operation data. The operation data includes data relating to the substrate width, and the conveyor width of each conveyor is adjusted based on the data.

Except for the control relating to the buffer conveyor 16, the control as to delivery of the substrate S between any successive two conveyors is performed such that the two conveyors are synchronously operated on the condition that the substrate S is placed on the upstream one of the two conveyors and the downstream one of the two conveyors is empty, namely, no substrates S are placed thereon. Whether or not the substrate S is placed on each conveyor is detected by a sensor provided in each conveyor. Each of the controllers 80-86 performs by itself delivery of the substrate S between two conveyors of the corresponding device, machine, or module as the control target thereof. However, each of the controllers 80-86 performs delivery of the substrate S between a conveyor of the corresponding device, machine, or module as the control target thereof and a conveyor of the device, the machine, or the module disposed on the upstream or downstream side thereof, by cooperating with any of the controllers 80-86 that controls the device, the machine, or the module disposed on the upstream or downstream side. The cooperation of the two controllers involves communication therebetween. Concretely, in the solder printing system, the controller 82a controls by itself delivery between of the conveyor 34 of the first shuttle conveyor 12a and the conveyor 40 of the front conveyor lane 36 in the upstream printer 14a or the conveyor 48 of the rear conveyor lane 38 in the upstream printer 14a and delivery between the conveyor 42 of the front conveyor lane 36 in the upstream printer 14a or the conveyor 48 of the rear conveyor lane 38 in the upstream printer 14a and the conveyor 34 of the second shuttle conveyor 12b. The controller 82b controls by itself delivery between the conveyor 42 of the front conveyor lane 36 in the downstream printer 14b or the conveyor 48 of the rear conveyor lane 38 in the downstream printer 14b and the conveyor 34 of the third shuttle conveyor 12c. However, delivery between the conveyor 34 of the second shuttle conveyor 12b and the conveyor 40 of the front conveyor lane 36 in the downstream printer 14b or the conveyor 48 of the rear conveyor lane 38 in the downstream printer 14b is controlled by cooperation of the controller 82a and the controller 82b while communicating with each other.

### <Operation Modes of Solder Printing System>

In the present electric-circuit production line, production work can be performed in parallel on the substrates S in mutually different two kinds (two-kind-substrate parallel production work). Further, production work can be performed on the substrates S in one kind (one-kind-substrate production work). In connection with the two sorts of production work, the solder printing system is capable of performing printing work in two different operation modes, more specifically, a two-lane parallel printing mode and a one-lane printing mode. The two operation modes and a method of starting and stopping the printing work in each operation mode in the solder printing system will be explained below.

### i) Two-Lane Parallel Printing Mode

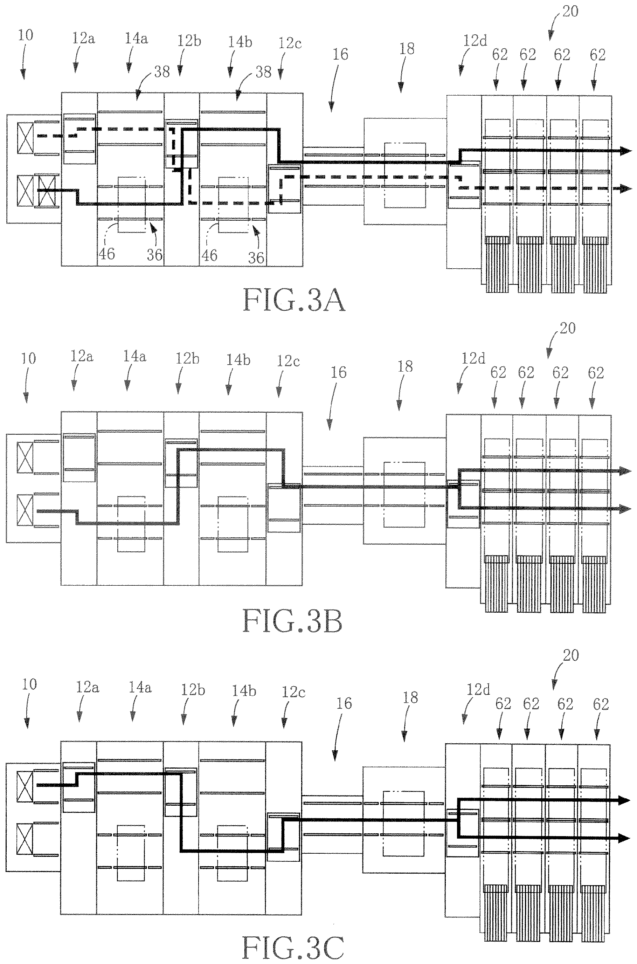

Fig. 3A shows the substrates that pass the electric-circuit production line in a state in which the solder printing system is performing the printing work in the two-lane parallel printing mode. The printing work performed by the solder printing system is classified into (A) first printing work and (B) second printing work. In the first printing work, solder printing is performed on the substrate S by the solder printing device 46 of the upstream printer 14a while the substrate S is being conveyed by the front conveyor lane 36 of the upstream printer 14a, and the substrate S is then conveyed by the rear conveyor lane 38 of the downstream printer 14b. In the second printing work, the substrate S is conveyed by the rear conveyor lane 38 of the upstream printer 14a, and solder printing is then performed on the substrate S by the solder printing device 46 of the downstream printer 14b while the substrate S is being conveyed by the front conveyor lane 36 of the downstream printer 14b. As apparent from Fig. 3, in the printing work performed in the two-lane parallel printing mode, the first printing work and the second printing work are performed in parallel. In this respect, in the solder printing system, the substrate S passes a route indicated by the bold solid line in the drawing when the first printing work is performed while the substrate S passes a route indicated by the bold broken line in the drawing when the second printing work is performed. This two-lane parallel printing mode is employed in both of the two-kind-substrate parallel production work and the one-kind-substrate production work.

In Fig. 3A, the substrates S stacked on the front-side table of the substrate supplier 10 are supplied to the front conveyor lane 36 of the upstream printer 14a for the first printing work and the substrates S stacked on the rear-side table are supplied to the rear conveyor lane 38 of the upstream printer 14a for the second printing work. In the one-kind-substrate production work, the substrates S may be stacked on only one of the two tables of the substrate supplier 10, and the substrates S may be supplied alternately to the front conveyor lane 36 and the rear conveyor lane 38 of the upstream printer 14a. In Fig. 3A, the substrate S on which the first printing work has performed is subjected to the component mounting work on the rear-side conveyor lane of the component mounter 20 while the substrate S on which the second printing work has been performed is subjected to the component mounting work on the front-side conveyor lane of the component mounter 20. In the one-kind-substrate production work, the component mounting work may be performed on any of the front-side conveyor lane and the rear-side conveyor lane of the component mounter 20, irrespective of which one of the first printing work and the second printing work has been performed on the substrate S.

### ii) One-Lane Printing Mode

Figs. 3B and 3C show the substrates that pass the electric-circuit production line in a state in which the solder printing system is performing printing work in the one-lane printing mode. In this respect, Fig. 3B shows the one-lane printing mode in which only the first printing work is performed and Fig. 3B shows the one-lane printing mode in which only the second printing work is performed. The one-lane printing mode is effective in an instance in which a tact of the work by the solder printing system in the one-lane printing mode (time pitch at which the substrates are output from the downstream printer 14b) is shorter than a tact of the work by the component mounter 20 (time pitch at which the component-mounted substrates S are output from the component mounter 20) when the component mounting work is performed in both of the front-side conveyor lane and the rear-side conveyor lane. This is because, in this case, a sufficient degree of productivity can be ensured by the solder printing work performed by only one of the two printers 14, in other words, without intentionally performing the solder printing work by both of the two printers 14.

In Figs. 3A and 3B, the substrates S stacked on one of the two tables of the substrate supplier 10 are supplied to the upstream printer 14a. The one of the two tables from which the substrates S are supplied may be either one of the two tables. The substrates S stacked on the two tables may be supplied alternately from the two tables. While, in the drawing, the substrates S output from the printing-result inspecting machine 18 are distributed to both of the front-side conveyor lane and the rear-side conveyor lane of the component mounter 20, the substrates S may be input to one of the two conveyor lanes and may be subjected to the mounting work on only the one conveyor lane.

### iii) Operation of Starting and Stopping Printing Work in Each Operation Mode

It is up to the operator to select in which one of the above-indicated two operation modes the printing work is to be performed. The printing work can be started in an arbitrary operation mode and the started printing work can be stopped, by operating an operation panel 88 (Fig. 1) of each of the upstream printer 14a and the downstream printer 14b. The operation panel 88 functions as an input/output device of the controller 82. It is noted that the operation for the upstream printer 14a and the operation for the downstream printer 14b are similarly performed.

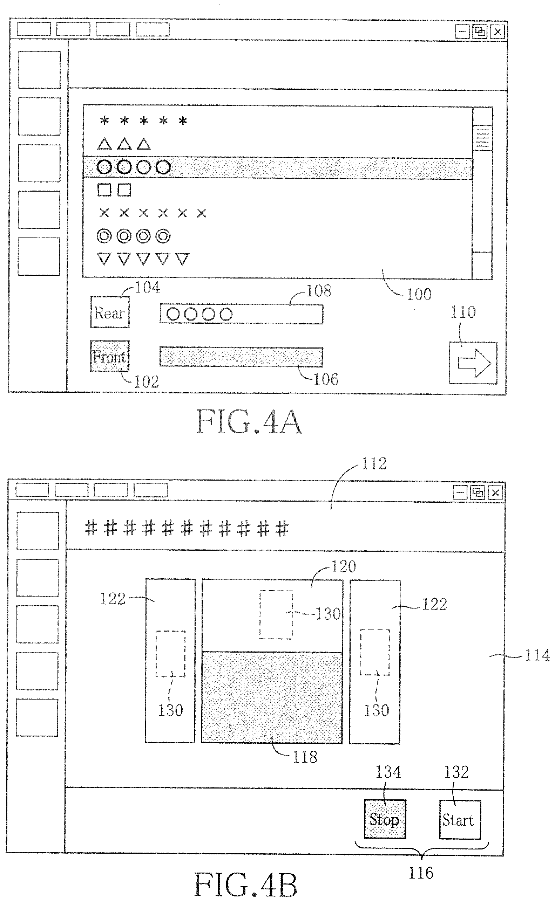

For starting the printing work by the solder printing system after the power is turned on, a screen shown in Fig. 4A is initially displayed on the operation panel 88. This screen is for selecting the conveyor lane (the front conveyor lane 36 or the rear conveyor lane 38) and for selecting the kind of the substrate S to be conveyed by the selected conveyor lane, namely, this screen is a lane and substrate-kind selecting screen. There are displayed, on the screen, a substrate-kind-list display area 100 in which a list of kinds of the substrate S is displayed, a front-conveyor-lane selecting switch 102 for switching the operation of the front conveyor lane 36 so as to be selectively permitted or prohibited, a rear-conveyor-lane selecting switch 104 for switching the operation of the rear conveyor lane 38 so as to be selectively permitted or prohibited, a substrate-kind display cell 106 in which is displayed the kind of the substrate S to be conveyed by the front conveyor lane 36 on which the work is to be performed on the substrate S when the operation of the front conveyor lane 36 is permitted, and a substrate-kind display cell 108 in which is displayed the kind of the substrate S to be conveyed by the rear conveyor lane 38 on which the work is to be performed on the substrate S when the operation of the rear conveyor lane 38 is permitted.

The operation panel 88 is the so-called touch panel. When the operator touches at least one of the front-conveyor-lane selecting switch 102 and the rear-conveyor-lane selecting switch 104, the operation of at least one of the front conveyor lane 36 and the rear conveyor lane 38 is permitted. To be more specific, where the solder printing system is operated in the one-lane printing mode, only one of the front-conveyor-lane selecting switch 102 and the rear-conveyor-lane selecting switch 104 is placed in the ON state. More specifically, where only the first printing work is performed, only the front-conveyor-lane selecting switch 102 is placed in the ON state for the upstream printer 14a while only the rear-conveyor-lane selecting switch 104 is placed in the ON state for the downstream printer 14b. Where only the second printing work is performed, only the rear-conveyor-lane selecting switch 104 is placed in the ON state for the upstream printer 14a while only the front-conveyor-lane selecting switch 102 is placed in the ON state for the downstream printer 14b. On the other hand, where the solder printing system is operated in the two-lane parallel printing mode, both of the two switches 102, 104 are placed in the ON state for both of the upstream printer 14a and the downstream printer 14b. The two switches 102, 104 appear bright in the ON state and appear dark in the OFF state. It is noted that, in Fig. 4A, only the rear-conveyor-lane selecting switch 104 is in the ON state.

By touching a portion of the substrate-kind-list display area 100 at which the substrate kind to be selected is being displayed immediately after one of the front-conveyor-lane selecting switch 102 and the rear-conveyor-lane selecting switch 104 has been placed in the ON state, the kind of the substrate S to be conveyed by the conveyor lane corresponding to the switch 102, 104 that has been placed in the ON state is selected. By the selection of the substrate kind, in the controller 82, the operation data, for the substrate S of the selected kind, of the printer 14 and the shuttle conveyor 12 that the controller 82 controls is copied from an operation-data storage area to a data storage area in which is stored data of the substrate for which the operation is permitted. Subsequently, preparations for the operation for the substrate S of the selected kind are made. More specifically, there are determined the conveyor width of the conveyors 40, 42, 44, 48 of the conveyor lane placed in the ON state, the conveyor width of the conveyor 34 of the shuttle conveyor 12 on which the substrate S is placed, the printing conditions by the solder printing device 46, and so on. The selected substrate kind is displayed on one of the substrate-kind display cell 106 for the front conveyor lane 36 and the substrate-kind display cell 108 for the rear conveyor lane 38. In this respect, Fig. 4A shows a state in which the substrate of the substrate kind "○○○○" is conveyed by the rear conveyor lane 38. Irrespective of the one-lane printing mode and the two-lane parallel printing mode, the same substrate kind is selected for the substrate S to be conveyed by the front conveyor lane 36 of the upstream printer 14a and the substrate S to be conveyed by the rear conveyor lane 38 of the downstream printer 14b, and the same substrate kind is selected for the substrate S to be conveyed by the rear conveyor lane 38 of the upstream printer 14a and the substrate S to be conveyed by the front conveyor lane 36 of the downstream printer 14b. In the above-indicated two-kind-substrate parallel production work, mutually different substrate kinds are selected for the substrate S to be conveyed by the front conveyor lane 36 and the substrate S to be conveyed by the rear conveyor lane 38, for each of the upstream printer 14a and the downstream printer 14b.

A touch on a next-screen transition switch 110 displayed on the screen after having determined the conveyor lane whose operation is permitted and the substrate kind of the substrate S to be conveyed by the conveyor lane causes a transition to a screen shown in Fig. 4B. The screen shown in Fig. 4B is an operation-status display screen on which is displayed an operation status of the printer 14 and the shuttle conveyor 12 that is controlled by the controller 82 of the printer 14. (The operation status is a concept that includes also an operation-prohibited state.) There are displayed, on this screen, a notifying area 112 for notifying the operator of the operation status by character information, a status-image display area 114 for permitting the operator to recognize the operation status by image information, and an operation permission-prohibition switch 116 configured to switch the operations of the printer 14 and the shuttle conveyor 12 controlled by the controller 82 of the printer 14 so as to be selectively permitted or prohibited.

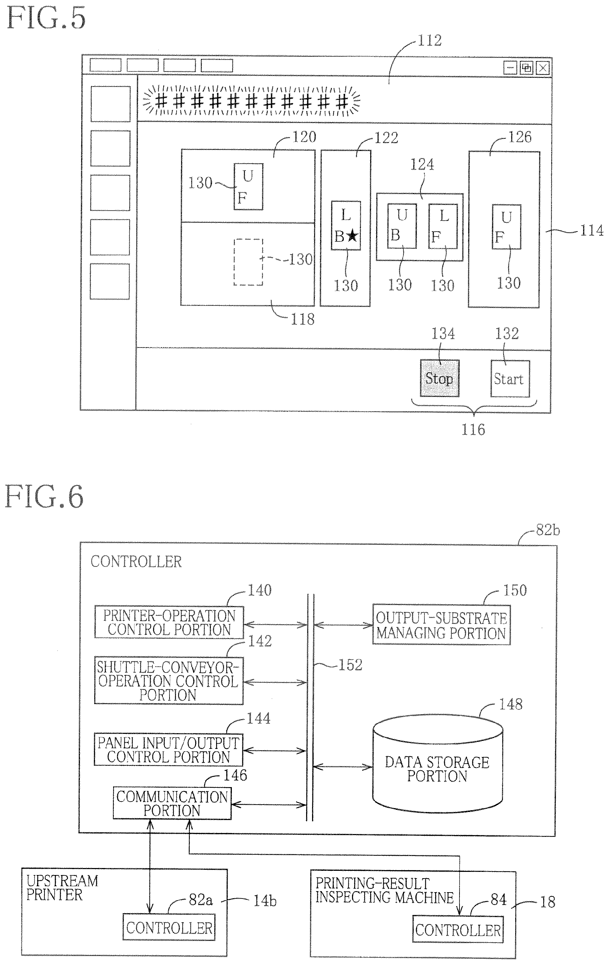

In the notifying area 112, there are displayed characters such as "front conveyor lane operating", "rear conveyor lane operating", or "both conveyor lanes operating", in accordance with the operation status of the front conveyor lane 36 and the rear conveyor lane 38. In the status-image display area 114, there are displayed images 118, 120 respectively representing the front conveyor lane 36 and the rear conveyor lane 38 of the printer 14 and images 122 representing the shuttle conveyors 12 controlled by the controller 82 of the printer 14 in conformity with the layout of the front conveyor lane 36, the rear conveyor lane 38, and the shuttle conveyors 12. The screen shown in Fig. 4B is an image of the operation panel 88 of the upstream printer 14a. In the screen of Fig. 4B, there are displayed the images 118, 120, 122, 122 respectively representing the front conveyor lane 36 of the upstream printer 14a, the rear conveyor lane 38 of the upstream printer 14a, the first shuttle conveyor 12a, and the second shuttle conveyor 12b. On the operation-status display screen of the operation panel 88 of the downstream printer 14b, there are displayed, in the status-image display area 114, the images 122, 124, 126 respectively representing the third shuttle conveyor 12c, the buffer conveyor 16, and the printing-result inspecting machine 18, in addition to the images 118, 120 respectively representing the front conveyor lane 36 and the rear conveyor lane 38 of the downstream printer 14b, as shown in Fig. 5. The screen shown in Fig. 5 will be later explained in detail.

The images 118-126 in the status-image display area 114 appear bright when the operations of the corresponding conveyor lanes, devices, and machine are permitted and appear dark when the operations are prohibited. When the images 118-126 appear bright, namely, where the operations are permitted, a substrate image 130 is displayed in each of the images 118-126 to indicate the presence or absence of the substrate S. The substrate image 130 is thickly displayed (by the solid line in the drawing, e.g., in Fig. 5) where the substrate S is present in the conveyor lanes, the devices, and the machine represented by the corresponding images 118-126 while the substrate image 130 is faintly displayed (by the broken line in the drawing) where the substrate S is not present. In this respect, Fig. 4B shows a state in which the operation of the rear conveyor lane 38 of the upstream printer 14a is permitted and the operation of the front conveyor lane 36 of the upstream printer 14a is not permitted. In the notifying area 112 of Fig. 4B, there are displayed characters such as "rear conveyor lane operating", for instance.

The operation-status display screen of Fig. 4B shows a state in which the operations of the rear conveyor lane 38 of the upstream printer 14a, the first shuttle conveyor 12a, and the second shuttle conveyor 12b are not permitted yet, and the operations are actually permitted by operating the operation permission-prohibition switch 116. The operation permission-prohibition switch 116 is constituted by a start button 132 and a stop button 134. The buttons 132, 134 appear bright when operable and appear dark when inoperable. Because the operations are not permitted yet in the state shown inn Fig. 4B, the start button 132 for permitting the operations appears bright while the stop button 134 for prohibiting the operations appears dark. On the contrary, in an instance where the operations are permitted, the start button 132 appears dark while the stop button 134 appears bright, as shown in Fig. 5. By touching the start button 132 in the state of Fig. 4B, the operations of the rear conveyor lane 38 of the upstream printer 14a, the first shuttle conveyor 12a, and the second shuttle conveyor 12b are permitted. That is, the operations are started. When the operations are started, the start button 132 becomes dark while the stop button 134 becomes bright. For stopping the started operations, namely, for prohibiting the operations, the stop button 134 being bright may be touched, and the touched stop button 134 becomes dark while the start button 132 becomes bright. Thus, the operation permission-prohibition switch 116 is the so-called toggle switch. It is noted that, in the state in which the operations are permitted, the characters displayed in the notifying area 112 of the operation-status display screen are blinking, thereby notifying the operator that the operations are permitted (Fig. 5).

The above-indicated operations on the operation panel 88 are performed for each of the upstream printer 14a and the downstream printer 14b, for thereby permitting only one of the two conveyor lanes of the upstream printer 14a, i.e., the rear conveyor lane 38, to be operated and permitting only one of the two conveyor lanes of the downstream printer 14b, i.e., the front conveyor lane 36, to be operated. As a result, the solder printing system operates in the one-lane printing mode for performing only the second printing work. On the contrary, by permitting only one of the two conveyor lanes of the upstream printer 14a, i.e., the front conveyor lane 36, to be operated and permitting only one of the two conveyor lanes of the downstream printer 14b, i.e., the rear conveyor lane 38, to be operated, the solder printing system operates in the one-lane printing mode for performing only the first printing work. On the other hand, by permitting both of the front conveyor lane 36 and the rear conveyor lane 38 of the upstream printer 14a to be operated and permitting both of the front conveyor lane 36 and the rear conveyor lane 38 of the downstream printer 14b to be operated, the solder printing system operates in the two-lane parallel printing mode for performing the first printing work and the second printing work in parallel.

In view of the operations described above, in the present solder printing system, it may be considered that each of the upstream printer 14a and the downstream printer 14b has a "front-conveyor-lane operation switch (first-conveyor-lane operation switch) for permitting only the front conveyor lane 36 thereof to be operated in the printing work in the one-lane printing mode. In this case, it may be considered that the switch is constituted by the front-conveyor-lane selecting switch 102 in the lane and substrate-kind selecting screen and the operation permission-prohibition switch 116 of the operation-status display screen. Further, it may be considered that each of the upstream printer 14a and the downstream printer 14b has a "rear-conveyor-lane operation switch (second-conveyor-lane operation switch) for permitting only the rear conveyor lane 38 thereof to be operated in the printing work in the one-lane printing mode. In this case, it may be considered that the switch is constituted by the rear-conveyor-lane selecting switch 104 of the lane and substrate-kind selecting screen and the operation permission-prohibition switch 116 of the operation-status display screen. Further, it may be considered that each of the upstream printer 14a and the downstream printer 14b has a "both-conveyor-lane operation switch" for permitting, at one time, both of the front conveyor lane 36 and the rear conveyor lane 38 thereof to be operated in the printing work in the two-lane parallel printing mode. In this case, it may be considered that the switch is constituted by the front-conveyor-lane selecting switch 102 and the rear-conveyor-lane selecting switch 104 of the lane and substrate-kind selecting screen and the operation permission-prohibition switch 116 of the operation-status display screen. In terms of the functions of the operation permission-prohibition switch 116, it may be considered that the front-conveyor-lane operation switch, the rear-conveyor lane operation switch, and the both-conveyor-lane operation switch are configured to switch the operation of the front conveyor lane 36, the operation of the rear conveyor lane 38, and the operations of the two conveyor lanes 36, 38, respectively, so as to be selectively permitted or prohibited.

In the present solder printing system, each of the upstream printer 14a and the downstream printer 14b is configured such that the characters displayed in the notifying area 112 of the operation-status display screen blink even where only one of the two conveyor lanes 36, 38, i.e., only the rear conveyor lane 38, to be operated. That is, in each of the upstream printer 14a and the downstream printer 14b, the operation panel 88 functions as the notifier for notifying the operator that only the rear conveyor lane 38 is permitted to be operated. Owing to the function as the notifier, even the operator who is involved in the work on the front side of the present electric-circuit production line can sufficiently recognize the operation only by the rear conveyor lane 38 that is difficult to visually recognize in the one-lane printing mode.

Further, in the present solder printing system, each of the upstream printer 14a and the downstream printer 14b is configured such that each of the front conveyor lane 36 and the rear conveyor lane 38 is operable independently. This configuration is effective for obviating a situation in which the substrate S is left on the rear conveyor lane 38 of the upstream printer 14a when the printing work in the one-lane printing mode for performing printing only by the solder printing device 46 of the upstream printer 14a is completed, for instance.

### <Management of Output Substrates>

In the present electric-circuit production line, there are disposed, on the downstream side of the solder printing system, circuit-substrate-related-operation performing apparatus (hereinafter simply referred to as "operation-performing apparatus" where appropriate) such as the printing-result inspecting machine 18 and the component mounter 20. In the operation-performing apparatus disposed on the downstream side, where any event that influences the quality of the electric circuits to be produced is found, it is preferable to grasp what work was performed in the solder printing system to find the cause. In particular, when the above-indicated one-kind-substrate production work is performed while the system is performing the printing work in the two-lane parallel printing mode, it is preferable to grasp which one of the upstream printer 14a and the downstream printer 14b was performed the printing work. In view of this, in the present solder printing system, the substrates S output from the system are managed by the controller 82b of the downstream printer 14b. The management will be concretely explained below.

### i) Functional Structure of Controller of Downstream Printer

The controller 82b of the downstream printer 14b is a device constituted mainly by a computer and has a functional structure indicated by the block diagram of Fig. 6. More specifically, the controller 82b has the following functional portions: a printer-operation control portion 140 configured to control the operations of the conveyors 40, 42, 44, 48 of the two conveyor lanes 36, 38 of the downstream printer 14b and the operation of the solder printing device 46 of the downstream printer 14b; a shuttle-conveyor-operation control portion 142 configured to control the operations of the shuttle base 32 and the conveyor 34 of the third shuttle conveyor 12c; a panel input/output control portion 144 configured to control input/output by the operation panel 88; a communication portion 146 configured to perform transmission and reception of various sorts of information and signals between the controller 82a of the upstream printer 14a and the controller 84 of the printing-result inspecting machine 18; and data storage portion 148 configured to store data such as the above-indicated operation data, for the substrate S, of the downstream printer 14b and the third shuttle conveyor. The controller 82b further has an output-substrate managing portion 150 as a functional portion to manage the substrates S output from the system. These functional portions are connected to one another via an internal bus 152.

### ii) Output-Substrate Management Table

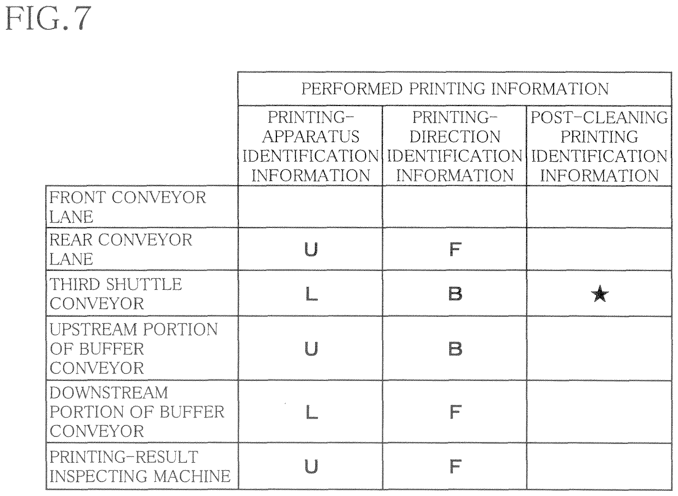

In the data storage portion 148, an output-substrate management table shown in Fig. 7 is set. On the basis of data stored in the output-substrate management table, the output substrates S are managed. The output-substrate management table is a table in which, in an instance where the substrate S is present at any of a plurality of positions (hereinafter referred to as "stages" where appropriate) at which the substrates S can be present, information (hereinafter referred to as "performed printing information" where appropriate) indicative of details of the printing work performed on the substrate S is stored in association with the stage. More specifically, rows of the table correspond to respective stages. In each of cells in one row corresponding to one stage at which the substrate S is present, there is stored the performed printing information of the substrate S present at the one stage.

As shown in Fig. 7, six stages are set corresponding to the front conveyor lane 36, the rear conveyor lane 38, the third shuttle conveyor 12c, an upstream portion of the buffer conveyor 16, a downstream portion of the buffer conveyor 16, and the printing-result inspecting machine 18. This setting is arbitrarily changeable through the operation panel 88. In Fig. 7, the printing-result inspecting machine 18 is set as a specific operation-performing apparatus, and the work position of the substrate S in the printing-result inspecting machine 18 is set as a final stage. However, any one of the component mounting modules 62 of the component mounter 20 may be set as the specific operation-performing apparatus, and the work position of the substrate S in the component mounting module 62 may be set as the final stage. Further, any one of other devices and machines may be set as the specific operation-performing apparatus, and the standby position or the work position of the substrate S therein may be set as the final stage. In the present electric-circuit production line, the buffer conveyor 16 is configured to have two standby positions. Accordingly, two stages are set between the printing-result inspecting machine 18 and the third shuttle conveyor 12c. The number of stages is changeable depending upon the length of the buffer conveyor 16, namely, depending upon the number of standby positions, for instance. In a case in which the buffer conveyor 16 is not disposed, it may be possible to eliminate stages corresponding thereto.

As shown in Fig. 7, the performed printing information includes three sorts of information, i.e., "printing-apparatus identification information", "printing-direction identification information", and "post-cleaning printing identification information". The three sorts of information correspond to respective three columns of the table. The three sorts of information are stored in cells each defined by one row corresponding to one stage at which the substrate S is present and a corresponding one of the three columns. The printing-apparatus identification information is information for identifying which one of the solder printing device 46 of the upstream printer 14a and the solder printing device 46 of the downstream printer 14b has printed solder cream on the substrate S. The letter "U" indicates that the solder printing device 46 of the upstream printer 14a has performed solder printing while the letter "L" indicates that the solder printing device 46 of the downstream printer 14b has performed solder printing. The printing-direction identification information is information for identifying in which direction the squeegee of the solder printing device 46 was moved when the printing was performed on the substrate S. The solder printing device 46 is configured to perform printing by moving the squeegee in one direction in the conveyance-width direction Dy. The letter "F" indicates that printing was performed by moving the squeegee from the rear side toward the front side, namely, by moving the squeegee in the advancing direction. The letter "B" indicates that printing was performed by moving the squeegee from the front side toward the rear side, namely, by moving the squeegee in the retracting direction. The solder printing device 46 has a cleaning mechanism for cleaning the lower surface of the mask prior to printing arbitrarily or based on a predetermined cleaning condition. The post-cleaning printing identification information is information for identifying one substrate as a substrate on which printing is initially performed after the mask has been cleaned by the cleaning mechanism (hereinafter referred to as "initially-printed substrate after cleaning" where appropriate). The symbol "★" indicates that the substrate S is the initially-printed substrate after cleaning. In Fig. 7, the above-indicated three sorts of performed printing information are set. Only at least one of the three sorts of performed printing information may be set or other information may be set in addition to the three sorts of performed printing information or in place of any of the three sorts of performed printing information.

### iii) Processing Relating to Output-Substrate Management Table

The output-substrate managing portion 150 manages the substrates output from the present system by processing relating to the output-substrate management table. As explained above, after the inspection work on one substrate S in the printing-result inspecting machine 18 has been completed, in synchronism with timing at which the one substrate S is output from the printing-result inspecting machine 18, two substrates that follow the one substrate S and that are located at the respective standby positions of the buffer conveyor 16 are conveyed (i.e., a downstream one of the two substrates S is input to the printing-result inspecting machine 18) and another substrate on the third shuttle conveyor 12c is input to the buffer conveyor 16. When these motions are performed, there are updated, in accordance with these motions, the three sorts of performed printing information stored in the respective rows in the output-substrate management table that respectively correspond to the third shuttle conveyor 12c, the upstream portion of the buffer conveyor 16, the downstream portion of the buffer conveyor 16, and the printing-result inspecting machine 18. More specifically, the information stored in the row corresponding to the printing-result inspecting machine 18 is deleted, and the information stored in the rows corresponding to the third shuttle conveyor, the upstream and downstream portions of the buffer conveyor 16 is transferred to the rows respectively corresponding to the upstream and downstream portions of the buffer conveyor 16 and the printing-result inspecting machine 18. In other words, every time one substrate S is output from the solder printing system, the information stored in the output-substrate management table of the data storage portion 148 is updated.

Further, when one substrate S is conveyed from one of the front conveyor lane 36 and the rear conveyor lane 38 of the downstream printer 14b to the third shuttle conveyor 12c, the performed printing information stored in the row corresponding to the one of the two conveyor lanes 36, 38 is transferred to the row corresponding to the third shuttle conveyor 12c, in accordance with the conveyance of the one substrate S. When one substrate S is input from the second shuttle conveyor 12b to the front conveyor lane 36, there is stored a character "L" in the cell for the printing-apparatus identification information in the row corresponding to the lane 36. Subsequently when printing is performed on the one substrate S, there is stored a letter "F" or "B" in the cell for the printing-direction identification information, in accordance with the movement direction of the squeegee in the printing. Further, where the one substrate S is the initially-printed substrate after cleaning, there is stored a symbol "★" in the cell for the post-cleaning printing identification information. On the other hand, when one substrate S is input from the second shuttle conveyor 12b to the rear conveyor lane 38, there is stored a letter "U" in the cell for the printing-apparatus identification information in the row corresponding to the lane 38. Further, on the basis of information sent from the controller 82a of the upstream printer 14a, the letter "F" or "B" is stored in the cell for the printing-direction identification information, in accordance with the movement direction of the squeegee in the printing performed on the one substrate S, and the symbol "★" is stored in the cell for the post-cleaning printing identification information where the one substrate S is the initially-printed substrate after cleaning.

### iv) Displaying on Operation Panel

The storage details in the output-substrate management table are displayed on the operation panel 88 of the downstream printer 14b via the panel input/output control portion 144. More specifically, as shown in Fig. 5, there are displayed, in the status-image display area 114 of the operation-status display screen, the images 124, 126 of the buffer conveyor 16 and the printing-result inspecting machine 18, in addition to the images 118, 120, 122 of the front conveyor lane 36 and the rear conveyor lane 38 of the downstream printer 14b and the third shuttle conveyor 12c. When one substrate S is present in one of the conveyor lanes, the devices, and the machine, the substrate image 130 in a corresponding one of the images 118-126 is thickly displayed, and the storage details of the output-substrate management table are displayed in that substrate image 130. More specifically, there are displayed, in the substrate image 130 corresponding to one of the above-indicated stages, details of the printing-apparatus identification information, the printing-direction identification information, and the post-cleaning printing identification stored in the respective cells of the output-substrate management table in the row corresponding to the stage, as symbols. In the status-image display area 114 of the operation-status display screen shown in Fig. 5, the storage details of the output-substrate management table of Fig. 7 are displayed.

The details displayed on the operation-status display screen of the operation panel 88, namely, whether each substrate image 130 is thickly displayed or faintly displayed and the symbol indicative of the performed printing information displayed in each substrate image 130 are updated in accordance with updating of the output-substrate management table described above. In other words, every time one substrate S is output from the solder printing system, the details displayed on the operation-status display screen of the operation panel 88 are updated. The images of the device and the machine disposed downstream of the third shuttle conveyor 12c that are displayed in the status-image display area 114 of the operation-status display screen are based on the setting of the stages of the output-substrate management table. The images of the device and the machine and the positions and the number of substrate images 130 displayed therein are changeable in accordance with a change in the setting of the stages.

### v) Functions of Controller and Operation panel Relating to Management of Output Substrates

The controller 82b of the downstream printer 14b executes the processing described above in connection with management of the output substrates. In view of this, the data storage portion 148 having the output-substrate management table and the output-substrate managing portion 150 that executes the processing relating to the table function as an information storage device configured to store the performed printing information for each of the substrates S output from the solder printing system in association with the order in which the substrates S are output. The data storage portion 148 and the output-substrate management portion 150 are configured to store the performed printing information of three substrates S present at respective three stages corresponding to the two standby positions of the substrates S in the buffer conveyor 16 and the work position of the substrate S in the printing-result inspecting machine 18 as the specific operation-performing apparatus. Accordingly, the information storage device is configured to store the performed printing information for one output substrate S until the inspection work by the printing-result inspecting machine 18 on the one output substrate S is completed, namely, until the work by the specific operation-performing apparatus is completed, and is configured to store the performed printing information for each of the substrates S including: a most-recently-output substrate S that is the most recently output from the solder printing system; and a preset number of substrates S that precede the most-recently-output substrate S. The preset number is equal to a number of substrates S that are output from the solder printing system in a time period from a time point when one substrate S is output from the system to a time point when the work by the specific operation-performing apparatus on that one substrate S is completed. More specifically, the preset number is equal to the number of stages (e.g., three in the embodiment) set so as to correspond to the buffer conveyor 16 and the printing-result inspecting machine 18.

The operation panel 88 of the downstream printer 14b displays as described above in connection with management of the output substrates. In view of this, the operation panel 88 functions as an information display device configured to display the details of the output-substrate management table stored in the data storage portion 148, namely, the performed printing information stored in the information storage device, for each of the substrates S output from the solder printing system, in association with the order in which the substrates S are output. The plurality of substrate images 130 are displayed in the status-image display area 114 of the operation-status display screen of the operation panel 88. Each of the substrate images 130 functions as an area for displaying the performed printing information of the substrate S present at the corresponding stage. Some of the substrate images 130 correspond to the work position of the substrate S in the printing-result inspecting machine 18 as the specific operation-performing apparatus and the standby positions at which the substrates S are kept on standby before reaching the printing-result inspecting machine 18. In the screen of Fig. 5, the two standby positions are set in the buffer conveyor 16, and the two substrate images 130 are displayed in the image 124 of the buffer conveyor 16. As explained above, the number of substrate images 130 is changeable in accordance with the number of standby positions.

### Description of Reference Signs

10: substrate supplier 12: shuttle conveyor (conveyor-lane changer) 12a: first shuttle conveyor (input-side lane changer) 12b: second shuttle conveyor (intermediate lane changer) 12c: third shuttle conveyor (output-side lane changer) 12d: fourth shuttle conveyor 14: printer 14a: upstream printer 14b: downstream printer 16: buffer conveyor 18: printing-result inspecting machine 20: component mounter 36: front conveyor lane of the printer (first conveyor lane) 38: rear conveyor lane of the printer (second conveyor lane) 46: solder printing device 58: printing-result inspecting device 62: component mounting module 68: component mounting device 82: controller of the printer 82a: controller of the upstream printer 82b: controller of the downstream printer 88: operation panel of the printer (information display device) 100: substrate-kind list display area 102: front-conveyor-lane selecting switch (first-conveyor-lane operation switch) (both-conveyor-lane operation switch) 104: rear-conveyor-lane selecting switch (second-conveyor-lane operation switch) (both-conveyor-lane operation switch) 112: notifying area 114: status-image display area 116: operation permission-prohibition switch (first-conveyor-lane operation switch) (second-conveyor-lane operation switch) (both-conveyor-lane operation switch) 130: substrate image 132: start button 134: stop button 144: panel input/output control portion 148: data storage portion (information storage device) 150: output-substrate managing portion (information storage device)

## Claims

1. A solder printing system, comprising:
an upstream printer (14a) and a downstream printer (14b) each including: (a) a first conveyor lane (36) and a second conveyor lane (38) which are disposed side by side in an intersecting direction that intersects a substrate conveyance direction and each of which is configured to convey a circuit substrate (S) in the substrate conveyance direction; and (b) a solder printing device (46) configured to print solder cream on the circuit substrate (S) conveyed by the first conveyor lane (36); and
a conveyor-lane changer (12b) disposed between the upstream printer (14a) and the downstream printer (14b) for inputting the circuit substrate (S) conveyed by the first conveyor lane (36) of the upstream printer (14a) into the second conveyor lane (38) of the downstream printer (14b) and inputting the circuit substrate (S) conveyed by the second conveyor lane (38) of the upstream printer (14a) into the first conveyor lane (36) of the downstream printer (14b),
wherein each of the upstream printer (14a) and the downstream printer (14b) has a controller (82a, 82b) for controlling a corresponding one of the upstream printer (14a) and the downstream printer (14b), the controller (82a, 82b) of one of the upstream printer (14a) and the downstream printer (14b) being configured to control also the conveyor-lane changer (12b), **characterized in that**
the solder printing system further comprises an information storage device (148, 150) to store performed printing information for each of the circuit substrates (S) output from the solder printing system, in association with an order in which the circuit substrates (S) are output, the performed printing information including printing-apparatus identification information that is information for identifying which one of the solder printing device (46) of the upstream printer (14a) and the solder printing device (46) of the downstream printer (14b) has printed the solder cream on said each of the circuit substrates (S) output from the solder printing system.

2. The solder printing system according to claim 1, further comprising an information display device (88) configured to display the performed printing information stored in the information storage device (148, 150) for said each of the circuit substrates (S) output from the solder printing system, in association with the order in which the circuit substrates (S) are output.

3. The solder printing system according to claim 2, which is disposed in an electric-circuit production line,
wherein the information display device (88) is configured to display a screen on which is set at least one display area (124, 126) that is associated with at least one of: (A) a standby position at which said each of the circuit substrates (S) output from the solder printing system is kept on standby before reaching a specific operation-performing apparatus (18, 20) disposed on a downstream side of the solder printing system; and (B) a work position in the specific operation-performing apparatus (18, 20),
wherein the information display device (88) being configured to display, on each of the at least one display area (124, 126), the performed printing information of one of the circuit substrates (S) that is located at a position corresponding to one of the at least one display area (124, 126).

4. The solder printing system according to claim 3,
wherein one of the at least one display area (124, 126) is associated with at least the standby position, and
wherein the information display device (88) is configured such that the number of at least one display area (124, 126) is changeable depending upon the number of standby positions.

5. The solder printing system according to any one of claims 1-4,
wherein the solder printing device (46) of each of the upstream printer (14a) and the downstream printer (14b) is configured to perform printing such that a squeegee is moved in one of opposite directions with a mask pressed onto the circuit substrate (S) and has a cleaning mechanism configured to clean the mask arbitrarily or based on a predetermined cleaning condition prior to the printing, and
wherein the performed printing information includes at least one of:
printing-direction identification information that is information for identifying in which one of the opposite directions the squeegee was moved when the solder printing device (46) performed printing on the circuit substrate (S); and
post-cleaning printing identification information that is information for identifying one circuit substrate (S) as an initially-printed circuit substrate (S) after cleaning that is a circuit substrate (S) on which the printing is initially performed after the mask has been cleaned by the cleaning mechanism.

## Patentansprüche

1. Lötdrucksystem, umfassend:
einen stromaufwärts gelegenen Drucker (14a) und einen stromabwärts gelegenen Drucker (14b), die jeweils umfassen: (a) eine erste Förderbahn (36) und eine zweite Förderbahn (38), die Seite an Seite in einer kreuzenden Richtung angeordnet sind, die eine Substratförderrichtung kreuzt und von denen jede konfiguriert ist, ein Schaltungssubstrat (S) in der Substratförderrichtung zu fördern; und (b) eine Lötdruckvorrichtung (46), die konfiguriert ist, Lötpaste auf das von der ersten Förderbahn (36) geförderte Schaltungssubstrat (S) zu drucken; und
einen Förderbahn-Wechsler (12b), der zwischen dem stromaufwärts gelegenen Drucker (14a) und dem stromabwärts gelegenen Drucker (14b) angeordnet ist, um das von der ersten Fördererbahn (36) des stromaufwärts gelegenen Druckers (14a) geförderte Schaltungssubstrat (S) in die zweite Förderbahn (38) des stromabwärts gelegenen Druckers (14b) einzuspeisen und das von der zweiten Förderbahn (38) des stromaufwärts gelegenen Druckers (14a) geförderte Schaltungssubstrat (S) in die erste Förderbahn (36) des stromabwärts gelegenen Druckers (14b) einzuspeisen,
wobei sowohl der stromaufwärts gelegene Drucker (14a) als auch der stromabwärts gelegene Drucker (14b) eine Steuerung (82a, 82b) zum Steuern eines dazugehörigen des stromaufwärts gelegenen Druckers (14a) und des stromabwärts gelegenen Druckers (14b) aufweisen, wobei die Steuerung (82a, 82b) von einem von dem stromaufwärts gelegenen Drucker (14a) und dem stromabwärts gelegenen Drucker (14b) konfiguriert ist, ebenfalls den Förderbahn-Wechsler (12b) zu steuern, **dadurch gekennzeichnet, dass**
das Lötdrucksystem ferner eine Informationsspeichervorrichtung (148, 150) umfasst, um ausgeführte Druckinformation für jedes der von dem Lötdrucksystem ausgegebenen Schaltungssubstrate (S) in Verbindung mit einer Reihenfolge zu speichern, in welcher die Schaltungssubstrate (S) ausgegeben werden, wobei die ausgeführte Druckinformation Druckvorrichtungs-Identifikationsinformation umfasst, welches Information zum Identifizieren ist, welche von der Lötdruckvorrichtung (46) des stromaufwärts gelegenen Druckers (14a) und der Lötdruckvorrichtung (46) des stromabwärts gelegenen Druckers (14b) die Lötpaste auf jedes der von dem Luftdrucksystem ausgegebenen Schaltungssubstrate (S) gedruckt hat.

2. Das Lötdrucksystem gemäß Anspruch 1, ferner umfassend eine Informations-Anzeigevorrichtung (88), die konfiguriert ist, die ausgeführte Druckinformation, die in der Informationsspeichervorrichtung (148, 150) für jedes der von dem Lötdrucksystem ausgegebenen Schaltungssubstrate (S) gespeichert ist, in Verbindung mit der Reihenfolge anzuzeigen, in welcher die Schaltungssubstrate (S) ausgegeben werden.

3. Das Lötdrucksystem gemäß Anspruch 2, welches in einer Produktionslinie elektrischer Schaltungen angeordnet ist,
wobei die Informations-Anzeigevorrichtung (88) konfiguriert ist, ein Bild anzuzeigen, auf dem mindestens ein Anzeigebereich (124, 126) eingestellt ist, der mit mindestens einem der nachfolgenden verknüpft ist: (A) einer Wartestellung, bei der jedes der von dem Lötdrucksystem ausgegebenen Schaltungssubstrate (S) bereitgehalten wird, bevor es eine spezifische prozessausführende Vorrichtung (18, 20), die an einer stromabwärts gelegenen Seite des Lötdrucksystems angeordnet ist, erreicht; und (B) eine Arbeitsstellung in der spezifischen prozessausführenden Vorrichtung (18, 20),
wobei die Informations-Anzeigevorrichtung (88) konfiguriert ist, auf jedem von dem mindestens einen Anzeigebereich (124, 126) die ausgeführte Druckinformation von einem der Schaltungssubstrate (S) anzuzeigen, welches an einer Position angeordnet ist, die zu einem von dem mindestens einen Anzeigebereich (124, 126) gehört.

4. Das Lötdrucksystem gemäß Anspruch 3,
wobei einer von dem mindestens einen Anzeigebereich (124, 126) mindestens mit der Wartestellung verknüpft ist, und
wobei die Informations-Anzeigevorrichtung (88) so konfiguriert ist, dass die Zahl von dem mindestens einen Anzeigebereich (124, 126) in Abhängigkeit von der Zahl der Wartestellungen veränderbar ist.

5. Das Lötdrucksystem gemäß einem der Ansprüche 1 bis 4,
wobei die Lötdruckvorrichtung (46) von jedem von dem stromaufwärts gelegenen Drucker (14a) und dem stromabwärts gelegenen Drucker (14b) konfiguriert ist, ein Drucken so auszuführen, dass eine Rakel in eine von entgegengesetzten Richtungen bewegt wird, wobei eine Maske auf das Schaltungssubstrat (S) gedrückt wird, und einen Reinigungsmechanismus aufweist, der konfiguriert ist, die Maske zufällig oder basierend auf einer vorbestimmten Reinigungsbedingung vor dem Drucken zu reinigen, und
wobei die ausgeführte Druckinformation mindestens eines der folgenden umfasst:
Druckrichtungs-Identifikationsinformation, welches Informationen zum Identifizieren ist, in welche der entgegengesetzten Richtungen die Rakel bewegt worden ist, als die Lötdruckvorrichtung (46) ein Drucken auf dem Schaltungssubstrat (S) ausgeführt hat; und
Nach-Reinigungs-Druckidentifikationsinformation, welches Information zum Identifizieren eines Schaltungssubstrats (S) als ein nach-dem-Reinigen-zuerstgedrucktes Schaltungssubstrat (S) ist, welches ein Schaltungssubstrat (S) ist, auf welchem das Drucken zuerst ausgeführt wird, nachdem die Maske durch den Reinigungsmechanismus gereinigt worden ist.

## Revendications

1. Système d'impression par soudure, comprenant:
une imprimante en amont (14a) et une imprimante en aval (14b) comprenant chacune: (a) une première voie de transport (36) et une seconde voie de transport (38) disposées côte à côte dans une direction d'intersection croisant une direction de transport du substrat et chacune d'elles est configurée pour transporter un substrat de circuit (S) dans la direction de transport du substrat ; et (b) un dispositif d'impression de soudure (46) configuré pour imprimer de la crème à braser sur le substrat de circuit (S) transporté par la première voie de transport (36); et
un changeur de voie de transporteur (12b) disposé entre l'imprimante en amont (14a) et l'imprimante en aval (14b) pour introduire le substrat de circuit (S) transporté par la première voie de transport (36) de l'imprimante en amont (14a) dans le second voie de transport (38) de l'imprimante en aval (14b) et pour introduire le substrat de circuit (S) transporté par la seconde voie de transport (38) de l'imprimante en amont (14a) dans la première voie de transport (36) de l'imprimante en aval (14b),
dans lequel chacune de l'imprimante en amont (14a) et de l'imprimante en aval (14b) comporte un dispositif de commande (82a, 82b) pour commander l'une correspondante de l'imprimante en amont (14a) et de l'imprimante en aval (14b), le dispositif de commande (82a, 82b) de l'une de l'imprimante en amont (14a) et de l'imprimante aval (14b) configurées pour commander également le changeur de voie de transporteur (12b), **caractérisé en ce que**
le système d'impression par soudure comprend en outre un dispositif de stockage d'informations (148, 150) pour stocker des informations d'impression exécutées pour chacun des substrats de circuit (S) issus du système d'impression par soudure, en association avec un ordre dans lequel les substrats de circuit (S) sont délivrés, les informations d'impression exécutées comprenant des informations d'identification d'appareil d'impression qui sont des informations permettant d'identifier lequel du dispositif d'impression par soudure (46) de l'imprimante en amont (14a) et du dispositif d'impression par soudure (46) de l'imprimante en aval (14b) a imprimé la crème à braser sur chacun des substrats de circuit (S) délivrés par le système d'impression par soudure.

2. Système d'impression par soudure selon la revendication 1, comprenant en outre un dispositif d'affichage d'informations (88) configuré pour afficher les informations d'impression effectuées qui sont stockées dans le dispositif de stockage d'informations (148, 150) pour chacun des substrats de circuit (S) délivrés en provenance du système d'impression par soudure, en association avec l'ordre dans lequel les substrats de circuit (S) sont délivrés.

3. Système d'impression par soudure selon la revendication 2, qui est disposé dans une ligne de production de circuit électrique,
dans lequel le dispositif d'affichage d'informations (88) est configuré pour afficher un écran sur lequel est placé au moins une zone d'affichage (124, 126) associée à au moins un élément parmi: (A) une position d'attente à laquelle chacun desdits circuits des substrats (S) délivrés par le système d'impression par soudure sont maintenus en attente avant d'atteindre un appareil (18, 20) remplissant une fonction spécifique, disposé sur un côté aval du système d'impression par soudure; et (B) une position de travail dans l'appareil (18, 20) remplissant une fonction spécifique,
dans lequel le dispositif d'affichage d'informations (88) est configuré pour afficher, sur chacune de ladite au moins une zone d'affichage (124, 126), les informations d'impression exécutées de l'un des substrats de circuit (S) sont situées à une position correspondant à l'une de ladite au moins une zone d'affichage (124, 126).

4. Système d'impression par soudure selon la revendication 3,
dans lequel une de ladite au moins une zone d'affichage (124, 126) est associée à ladite au moins une position d'attente, et
dans lequel le dispositif d'affichage d'informations (88) est configuré de telle sorte que le nombre de ladite au moins une zone d'affichage (124, 126) peut être modifié en fonction du nombre de positions d'attente.

5. Système d'impression par soudure selon l'une quelconque des revendications 1-4,
dans lequel le dispositif d'impression par soudure (46) de chacune de l'imprimante en amont (14a) et de l'imprimante en aval (14b) est configuré pour effectuer une impression de sorte qu'une raclette est déplacée dans l'une des directions opposées avec un masque pressé sur le substrat de circuit (S) et possède un mécanisme de nettoyage configuré pour nettoyer le masque de manière arbitraire ou sur la base d'une condition de nettoyage prédéterminée avant l'impression, et
dans lequel l'information d'impression effectuée comprend au moins l'un des éléments suivants:
des informations d'identification de direction d'impression qui sont des informations permettant d'identifier dans laquelle des directions opposées, la raclette a été déplacée lorsque le dispositif d'impression par soudure (46) a effectué une impression sur le substrat de circuit (S); et
des informations d'identification d'impression de post-nettoyage qui sont des informations permettant d'identifier un substrat de circuit (S) comme substrat de circuit imprimé initial (S) après nettoyage qui est un substrat de circuit (S) sur lequel l'impression est initialement effectuée après nettoyage du masque par le mécanisme de nettoyage.
